# EUROPEAN PATENT APPLICATION

(11) **EP 4 794 500 A1**
(43) Date of publication of application: **19.08.2026**
(21) Application number: 25213299.8
(22) Date of filing: 04.11.2025
(51) Int. Cl.: H10K 59/80, H10K 59/122, H10K 59/38, H10K 59/35

(54) **DISPLAY APPARATUS AND ELECTRONIC DEVICE INCLUDING THE SAME**

(30) Priority: 14.02.2025 KR 20250019628
(71) Applicant: Samsung Display Co., Ltd., Yongin-si, Gyeonggi-do 17113 (KR)
(72) Inventor: Lee, Dongha, 17113 Yongin-si, Gyeonggi-do (KR); Kang, Yoonho, 17113 Yongin-si, Gyeonggi-do (KR)
(74) Representative: Gulde & Partner

(57) **Abstract**

A display apparatus includes a substrate, sub-pixels including first color sub-pixels, a first bank layer including lower openings defining an emission area in each of the sub-pixels, a second bank layer on the first bank layer, and light control patterns spaced apart from each other on the first bank layer. The light control patterns include first light control patterns respectively corresponding to the first color sub-pixels. The first light control patterns include a first-1 light control pattern and a first-2 light control pattern respectively corresponding to two first color sub-pixels adjacent to each other among the first color sub-pixels. In a plan view, the first-1 light control pattern and the first-2 light control pattern are at different positions in at least one of a first direction or a second direction perpendicular to the first direction with respect to a center of the first color sub-pixel corresponding thereto.

## Description

### CROSS-REFERENCE TO RELATED APPLICATION

### BACKGROUND

### 1. Field

Aspects of some embodiments of the present disclosure relate to a display apparatus and an electronic device including the same.

### 2. Description of the Related Art

Display apparatuses are configured to visually display data. Display apparatuses may be used as displays for small products such as mobile phones or large products such as televisions.

A display apparatus includes sub-pixels configured to receive electrical signals and emit light so as to externally display images. Each of the sub-pixels includes a light-emitting element. For example, in the case of an organic light-emitting display apparatus, an organic light-emitting diode is included as the light-emitting element. In general, an organic light-emitting display apparatus includes a thin-film transistor and an organic light-emitting diode on a substrate. The organic light-emitting diode operates to emit light on its own.

Recently, as the usage of display apparatuses has diversified, various attempts have been made to relatively improve the quality of display apparatuses.

The above information disclosed in this Background section is only for enhancement of understanding of the background and therefore the information discussed in this Background section does not necessarily constitute prior art.

### SUMMARY

One or more embodiments include a display apparatus having excellent display quality and relatively improved interference patterns due to external light reflection and diffraction and an electronic device including the display apparatus. However, this is only an example and the scope of embodiments according to the present disclosure is not limited thereby.

Additional aspects will be set forth in part in the description which follows and, in part, will be apparent from the description, or may be learned by practice of the presented embodiments of the disclosure.

According to one or more embodiments, a display apparatus includes a substrate, sub-pixels including first color sub-pixels, second color sub-pixels and third color sub-pixels each including a sub-pixel electrode on the substrate, an emission layer on the sub-pixel electrode, and an opposite electrode on the emission layer, a first bank layer including lower openings defining an emission area in each of the sub-pixels, a second bank layer on the first bank layer and including upper openings respectively overlapping the lower openings, a light control layer including light control patterns spaced apart from each other on the first bank layer and respectively corresponding to the sub-pixels, and color filters on the second bank layer and including first color filters, second color filters, and third color filters, wherein the light control patterns include first light control patterns respectively corresponding to the first color sub-pixels, second light control patterns respectively corresponding to the second color sub-pixels, and third light control patterns respectively corresponding to the third color sub-pixels, the first light control patterns include a first-1 light control pattern and a first-2 light control pattern respectively corresponding to two first color sub-pixels adjacent to each other among the first color sub-pixels, and in a plan view, the first-1 light control pattern and the first-2 light control pattern are at different positions in at least one of a first direction or a second direction perpendicular to the first direction with respect to a center of the first color sub-pixel corresponding thereto.

According to some embodiments, the second light control patterns may include a second-1 light control pattern and a second-2 light control pattern respectively corresponding to two second color sub-pixels adjacent to each other among the second color sub-pixels, and in a plan view, the second-1 light control pattern and the second-2 light control pattern may be at different positions in at least one of the first direction or the second direction with respect to a center of the second color sub-pixel corresponding thereto.

According to some embodiments, the third light control patterns may include a third-1 light control pattern and a third-2 light control pattern respectively corresponding to two third color sub-pixels adjacent to each other among the third color sub-pixels, and in a plan view, the third-1 light control pattern and the third-2 light control pattern may be at different positions in at least one of the first direction or the second direction with respect to a center of the third color sub-pixel corresponding thereto.

According to some embodiments, in a plan view, each of the light control patterns may be in an emission area of a corresponding sub-pixel among the sub-pixels.

According to some embodiments, in a plan view, each of the light control patterns may have an area corresponding to 10 % to 80 % of an area of an emission area of a corresponding sub-pixel among the sub-pixels.

According to some embodiments, the display apparatus may further include an encapsulation layer on the first bank layer, and a touch sensor layer between the encapsulation layer and the second bank layer, wherein the light control layer may be directly on the touch sensor layer.

According to some embodiments, each of the light control patterns may be in a corresponding upper opening among the upper openings of the second bank layer.

According to some embodiments, the light control patterns may be spaced apart from the second bank layer.

According to some embodiments, a thickness of the second bank layer may be greater than a thickness of each of the light control patterns.

According to some embodiments, the color filters may be on the light control patterns, and each of the color filters may cover a top surface and a side surface of a corresponding light control pattern among the light control patterns.

According to some embodiments, in a plan view, each of the light control patterns may have a circular shape, an elliptical shape, or a polygonal shape.

According to some embodiments, in a plan view, the first light control patterns may have a same size, the second light control patterns may have a same size, and the third light control patterns may have a same size. For example, each of the first light control patterns may have the same size, each of the second light control patterns may have the same size, and each of the third light control patterns may have the same size.

According to some embodiments, each of the light control patterns may include a scattering pattern.

According to some embodiments, each of the light control patterns may include a scattering pattern and a light-blocking pattern on the scattering pattern.

According to some embodiments, in a plan view, the light-blocking pattern of each of the light control patterns may have a same shape (or the same shape) as a shape of the scattering pattern.

According to some embodiments, a width of the scattering pattern of each of the light control patterns may be greater than or equal to a width of the light-blocking pattern.

According to some embodiments, a thickness of the scattering pattern of each of the light control patterns may be equal to a thickness of the light-blocking pattern.

According to some embodiments, the light-blocking pattern of each of the light control patterns may include a same material as a material of the second bank layer.

According to one or more embodiments, an electronic device includes a display apparatus including a display module, a processor, a memory, and a power module, wherein the display apparatus includes a substrate, sub-pixels including first color sub-pixels, second color sub-pixels and third color sub-pixels each including a sub-pixel electrode on the substrate, an emission layer on the sub-pixel electrode, and an opposite electrode on the emission layer, a first bank layer including lower openings defining an emission area in each of the sub-pixels, a second bank layer on the first bank layer and including upper openings respectively overlapping the lower openings, a light control layer including light control patterns spaced apart from each other on the first bank layer and respectively corresponding to the sub-pixels, and color filters on the second bank layer and including first color filters, second color filters, and third color filters, wherein the light control patterns include first light control patterns respectively corresponding to the first color sub-pixels, second light control patterns respectively corresponding to the second color sub-pixels, and third light control patterns respectively corresponding to the third color sub-pixels, the first light control patterns include a first-1 light control pattern and a first-2 light control pattern respectively corresponding to two first color sub-pixels adjacent to each other among the first color sub-pixels, and in a plan view, the first-1 light control pattern and the first-2 light control pattern are at different positions in at least one of a first direction or a second direction perpendicular to the first direction with respect to a center of the first color sub-pixel corresponding thereto.

According to some embodiments, in a plan view, each of the light control patterns may be in an emission area of a corresponding sub-pixel among the sub-pixels.

According to some embodiments, the color filters may be respectively on the light control patterns, and each of the color filters may cover a top surface and a side surface of a corresponding light control pattern among the light control patterns.

According to some embodiments, each of the light control patterns may include a scattering pattern.

According to some embodiments, each of the light control patterns may include a scattering pattern and a light-blocking pattern on the scattering pattern.

### BRIEF DESCRIPTION OF THE DRAWINGS

The above and other aspects, features, and characteristics of certain embodiments of the disclosure will be more apparent from the following description taken in conjunction with the accompanying drawings, in which:
FIG. 1 is a schematic perspective view of a display apparatus according to some embodiments;
FIG. 2 illustrates a light-emitting diode and a sub-pixel circuit connected thereto, which are provided in a sub-pixel of a display apparatus according to some embodiments;
FIG. 3 is a schematic cross-sectional view of the display apparatus taken along the line I-I' of FIG. 1, according to some embodiments;
FIG. 4 is a schematic cross-sectional view of a display apparatus according to some embodiments;
FIG. 5 is a schematic enlarged cross-sectional view of region X of the display apparatus of FIG. 4 according to some embodiments;
FIG. 6 is a plan view illustrating a layout of sub-pixels in a portion of a display apparatus according to some embodiments;
FIG. 7 is a plan view illustrating some sub-pixels and light control patterns corresponding thereto in a display apparatus according to some embodiments;
FIG. 8 is a cross-sectional view schematically illustrating a portion of the display apparatus taken along the lines A-A' and B-B' of FIG. 7, according to some embodiments;
FIGS. 9A to 9C are plan views illustrating some sub-pixels and light control patterns corresponding thereto in a display apparatus according to some embodiments;
FIG. 10 is a plan view illustrating some sub-pixels and light control patterns corresponding thereto in a display apparatus according to some embodiments;
FIG. 11 is a plan view illustrating some sub-pixels and light control patterns corresponding thereto in a display apparatus according to some embodiments;
FIG. 12 is a plan view illustrating some sub-pixels and light control patterns corresponding thereto in a display apparatus according to some embodiments;
FIG. 13 is a plan view illustrating some sub-pixels and light control patterns corresponding thereto in a display apparatus according to some embodiments;
FIG. 14 is a cross-sectional view schematically illustrating a portion of the display apparatus taken along the lines C-C' and D-D' of FIG. 13, according to some embodiments;
FIG. 15 is a plan view illustrating some sub-pixels and light control patterns corresponding thereto in a display apparatus according to some embodiments;
FIG. 16 is a cross-sectional view schematically illustrating a portion of a display apparatus taken along the lines F-F', G-G', and H-H' of FIG. 15, according to some embodiments;
FIG. 17 is a plan view illustrating some sub-pixels and light control patterns corresponding thereto in a portion of a display apparatus according to some embodiments;
FIG. 18 is a schematic cross-sectional view of a display apparatus according to some embodiments;
FIG. 19 is a schematic enlarged cross-sectional view of region XI of the display apparatus of FIG. 18 according to some embodiments;
FIG. 20 is a schematic enlarged cross-sectional view of region XI of the display apparatus of FIG. 18 according to some embodiments;
FIG. 21 is a plan view illustrating some sub-pixels and light control patterns corresponding thereto in a display apparatus according to some embodiments;
FIG. 22 is a block diagram of an electronic device according to some embodiments; and
FIG. 23 is schematic diagrams of electronic devices according to some embodiments.

### DETAILED DESCRIPTION

Reference will now be made in more detail to aspects of some embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As the present description allows for various changes and numerous embodiments, certain embodiments will be illustrated in the drawings and described in more detail in the written description. Effects and features of the disclosure, and methods of achieving them will be clarified with reference to embodiments described below in more detail with reference to the drawings. However, the disclosure is not limited to the following embodiments and may be embodied in various forms.

Hereinafter, aspects of some embodiments will be described in more detail with reference to the accompanying drawings. When describing embodiments with reference to the accompanying drawings, the same or corresponding elements are denoted by the same reference numerals, and redundant descriptions thereof are omitted.

In the following embodiments, the terms "first," "second," etc. are not used in a restrictive sense and are used to distinguish one element from another.

The singular forms as used herein are intended to include the plural forms as well unless the context clearly indicates otherwise.

It will be further understood that the terms "include" and/or "comprise" as used herein specify the presence of stated features or elements, but do not preclude the presence or addition of one or more other features or elements.

It will be further understood that, when a layer, region, or element is referred to as being "on" another layer, region, or element, it may be directly on the other layer, region, or element, but also intervening layers, regions, or elements may be present therebetween.

Also, sizes of elements in the drawings may be exaggerated or reduced for convenience of explanation. For example, because sizes and thicknesses of elements in the drawings are arbitrarily illustrated for convenience of explanation, the disclosure is not necessarily limited thereto.

When a certain embodiment is implemented differently, a specific process sequence may be performed differently from a sequence described herein. For example, two consecutively described processes may be performed substantially at the same time or performed in an order opposite to the stated order.

Throughout the disclosure, the expression "A and/or B" indicates only A, only B, or both A and B. In addition, the expression "at least one of A or B" indicates only A, only B, or both A and B.

It will be further understood that when layers, regions, or elements are referred to as being connected to each other, they may be directly connected to each other or indirectly connected to each other with intervening layers, regions, or elements therebetween. For example, when layers, regions, or elements are referred to as being electrically connected to each other, they may be directly electrically connected to each other or indirectly electrically connected to each other with intervening layers, regions, or elements therebetween.

The x-axis, the y-axis, and the z-axis are not limited to three axes of the rectangular coordinate system and may be interpreted in a broader sense. For example, the x-axis, the y-axis, and the z-axis may be perpendicular to one another or may represent different directions that are not perpendicular to one another.

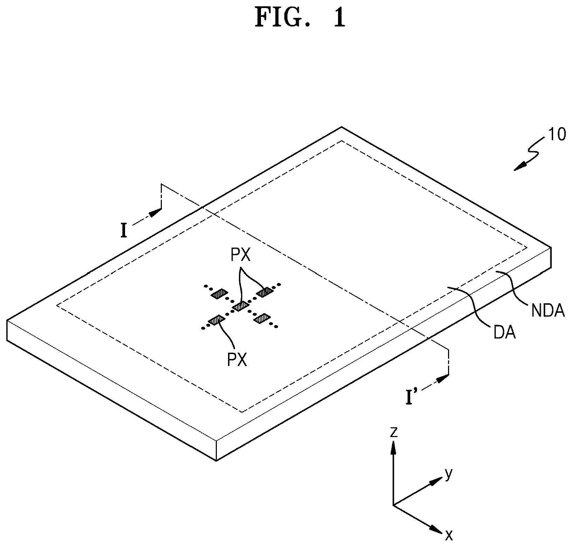

FIG. 1 is a schematic perspective view of a display apparatus 10 according to some embodiments.

Referring to FIG. 1, the display apparatus 10 may include a display area DA and a peripheral area NDA outside the display area DA. The display apparatus 10 may display images through an array of a plurality of sub-pixels PX two-dimensionally arranged in the display area DA.

The sub-pixels PX of the display apparatus 10 are areas in which pieces of light (or light) of certain colors are emitted, and the display apparatus 10 may provide images by using the pieces of light (or the light) emitted from the sub-pixels PX. For example, each of the sub-pixels PX may be configured to externally emit red light, green light, blue light, or white light.

Each of the sub-pixels PX may be configured to externally emit light of a certain color by using a light-emitting diode, for example, an organic light-emitting diode. The organic light-emitting diode may be configured to externally emit, for example, red light, green light, blue light, or white light. The organic light-emitting diode may be connected to a sub-pixel circuit including a thin-film transistor and a capacitor.

The peripheral area NDA is an area in which images are not displayed and may completely surround (e.g., in a periphery or outside a footprint of) the display area DA. A driver or a main power line configured to provide electrical signals or power to sub-pixel circuits may be located in the peripheral area NDA. A pad, which is an area to which an electronic element or a printed circuit board is electrically connectable, may be located in the peripheral area NDA.

The display area DA may have a polygonal shape such as a rectangular shape, as illustrated in FIG. 1. For example, the display area DA may have a rectangular shape in which a horizontal length is greater than a vertical length, a rectangular shape in which a horizontal length is less than a vertical length, or a square shape. Alternatively, the display area DA may have other shapes, such as an elliptical shape, a circular shape, or an irregular shape.

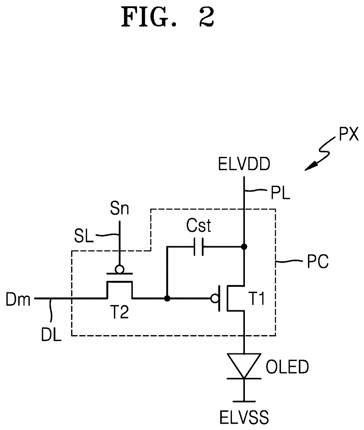

FIG. 2 illustrates a light-emitting diode and a sub-pixel circuit connected thereto, which are provided in a sub-pixel of a display apparatus according to some embodiments.

Referring to FIG. 2, as a light-emitting diode, an organic light-emitting diode OLED may be connected to a sub-pixel circuit PC. The sub-pixel circuit PC may include a first thin-film transistor T1, a second thin-film transistor T2, and a storage capacitor Cst.

The second thin-film transistor T2, which acts as a switching thin-film transistor, may be connected to a scan line SL and a data line DL and may be configured to transmit, to the first thin-film transistor T1, a data signal Dm input from the data line DL in response to a scan voltage or a scan signal Sn input from the scan line SL.

The storage capacitor Cst may be electrically connected to the second thin-film transistor T2 and a driving voltage line PL and may be configured to store a voltage corresponding to the difference between a voltage received from the second thin-film transistor T2 and a driving voltage ELVDD supplied to the driving voltage line PL.

The first thin-film transistor T1, which acts as a driving thin-film transistor, may be electrically connected to the driving voltage line PL and the storage capacitor Cst and may be configured to control a driving current flowing from the driving voltage line PL to the organic light-emitting diode OLED according to a voltage value stored in the storage capacitor Cst. The organic light-emitting diode OLED may be configured to externally emit light with a certain luminance according to the driving current. A sub-pixel electrode (e.g., an anode) of the organic light-emitting diode OLED may be electrically connected to the sub-pixel circuit PC. An opposite electrode (e.g., a cathode) of the organic light-emitting diode OLED may be configured to receive a common voltage ELVSS.

FIG. 2 illustrates that the sub-pixel circuit PC includes two thin-film transistors and one storage capacitor, but according to some embodiments, the number of thin-film transistors or the number of storage capacitors may be variously changed according to the design of the sub-pixel circuit PC. For example, according to various embodiments, the sub-pixel circuit PC may include additional components.

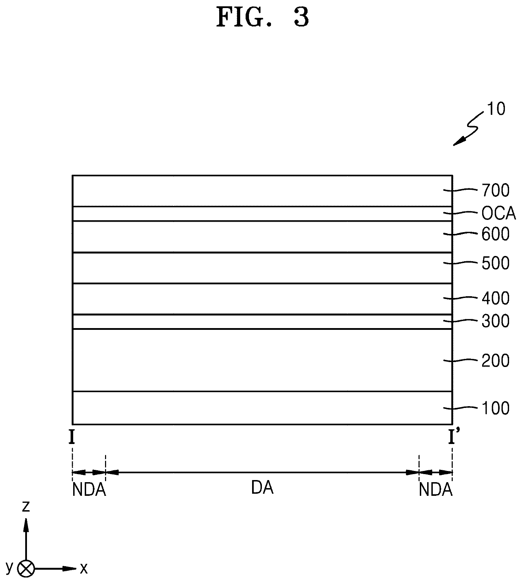

FIG. 3 is a schematic cross-sectional view of the display apparatus 10 taken along the line I-I' of FIG. 1, according to some embodiments.

Referring to FIG. 3, the display apparatus 10 may include a substrate 100, a display layer 200, a low-reflection layer 300, an encapsulation layer 400, a touch sensor layer 500, an anti-reflection layer 600, an adhesive layer OCA, and a cover window 700.

The substrate 100 may include glass or polymer resin. For example, the polymer resin may include polyethersulfone, polyacrylate, polyether imide, polyethylene naphthalate, polyethylene terephthalate, polyphenylene sulfide, polyarylate, polyimide, polycarbonate, or cellulose acetate propionate. The substrate 100 including the polymer resin may be flexible, rollable, or bendable. The substrate 100 may have a multilayer structure including a polymer resin-containing layer and an inorganic layer.

The display layer 200 may include thin-film transistors electrically connected to light-emitting diodes, for example, organic light-emitting diodes, and insulating layers between elements of the thin-film transistors.

The low-reflection layer 300 may be located on the display layer 200, and the encapsulation layer 400 may be located on the low-reflection layer 300. For example, the display layer 200 and/or the low-reflection layer 300 may be sealed by the encapsulation layer 400. According to some embodiments, the low-reflection layer 300 may be omitted. In this case, the encapsulation layer 400 may be located directly on the display layer 200. The encapsulation layer 400 may include at least one inorganic encapsulation layer and at least one organic encapsulation layer.

According to some embodiments, instead of the encapsulation layer 400, an encapsulation substrate including a glass material may be provided. The encapsulation substrate may be located on the display layer 200, and the display layer 200 may be located between the substrate 100 and the encapsulation substrate. A gap may exist between the encapsulation substrate and the display layer 200, and the gap may be filled with a filler.

The touch sensor layer 500 may be located on the encapsulation layer 400. The touch sensor layer 500 may be configured to sense an external input, for example, a touch of an object, such as a finger or a stylus pen, so that the display apparatus 10 may obtain coordinate information corresponding to a touch position. The touch sensor layer 500 may include touch electrodes and trace lines connected to the touch electrodes. The touch sensor layer 500 may be configured to sense an external input by using a mutual capacitance method or a self-capacitance method.

The touch sensor layer 500 may be located directly on the encapsulation layer 400. Alternatively, the touch sensor layer 500 may be formed separately and then bonded to the encapsulation layer 400 through an adhesive layer, such as an optically clear adhesive.

The anti-reflection layer 600 may be located on the touch sensor layer 500. The anti-reflection layer 600 may reduce the reflectance of external light incident from the outside toward the display apparatus 10 through the cover window 700.

The anti-reflection layer 600 may include color filters and a layer including a light-blocking material. The color filters may be arranged by taking into account the color of light emitted from each of the light-emitting diodes of the display layer 200. According to some embodiments, the anti-reflection layer 600 may include a light control layer. The light control layer may include light control patterns spaced apart from each other. The light control patterns may be arranged to correspond to the light-emitting diodes of the display layer 200, respectively. The light control patterns may include scattering patterns including scattering particles and/or light-blocking patterns including a light-blocking material.

The cover window 700 may be located on the anti-reflection layer 600. The cover window 700 may protect the layers located therebelow. The cover window 700 may be formed separately and then attached to the anti-reflection layer 400 by the adhesive layer OCA located between the cover window 700 and the anti-reflection layer 600. The adhesive layer OCA may be, for example, an optically clear adhesive. Alternatively, the cover window 700 may be directly formed on the anti-reflection layer 600.

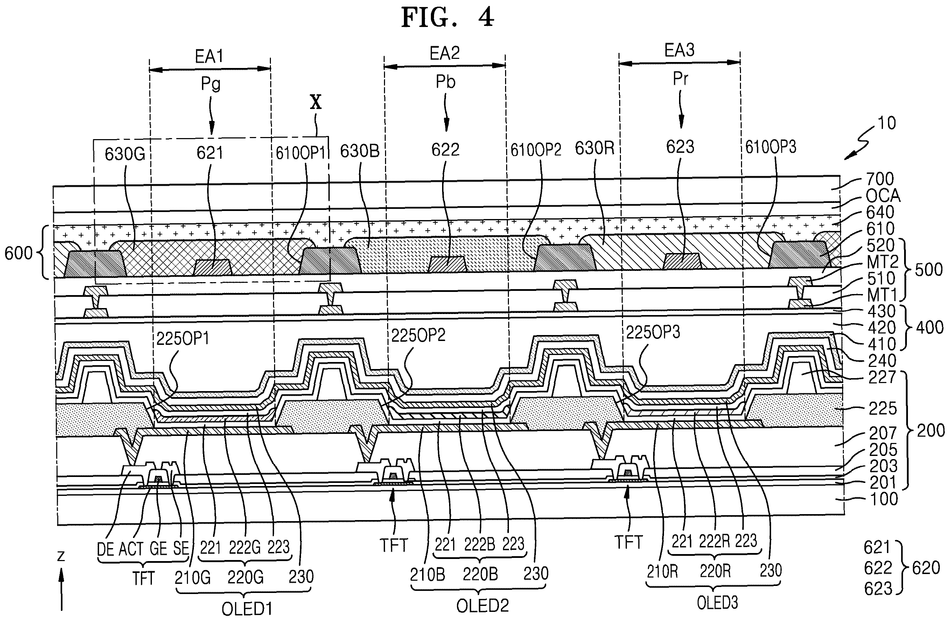

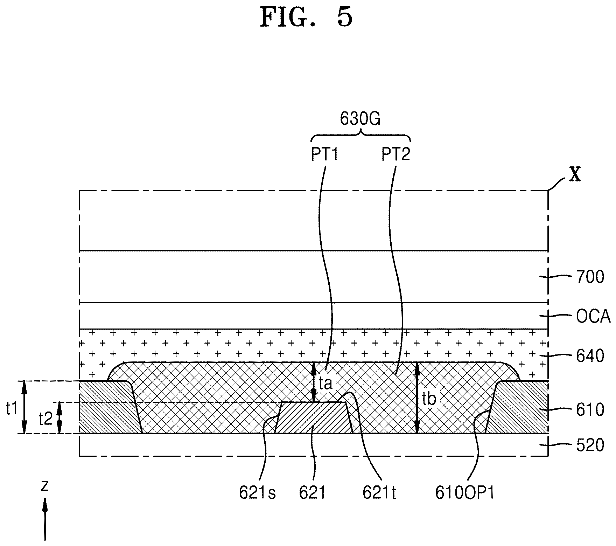

FIG. 4 is a schematic cross-sectional view of a display apparatus 10 according to some embodiments. FIG. 5 is a schematic enlarged cross-sectional view of region X of the display apparatus 10 of FIG. 4 according to some embodiments.

Referring to FIG. 4, the display apparatus 10 may include a substrate 100, a display layer 200, an encapsulation layer 400, a touch sensor layer 500, an anti-reflection layer 600, an adhesive layer OCA, and a cover window 700.

The display apparatus 10 may include sub-pixels located in a display area (see DA of FIG. 3). Each of the sub-pixels may be configured to externally emit red light, green light, or blue light. The sub-pixels may include sub-pixels configured to emit different colors, for example, a first color sub-pixel, a second color sub-pixel, and a third color sub-pixel. Each of the first color sub-pixel, the second color sub-pixel, and the third color sub-pixel may be provided in plurality. According to some embodiments, the first color sub-pixel may be a green sub-pixel Pg configured to emit green light, the second color sub-pixel may be a blue sub-pixel Pb configured to emit blue light, and the third color sub-pixel may be a red sub-pixel Pr configured to emit red light.

The display layer 200 may be located on the substrate 100. The display layer 200 may include a sub-pixel circuit layer and a light-emitting diode layer. The sub-pixel circuit layer may include thin-film transistors TFT and may include insulating layers, such as a buffer layer 201, a gate insulating layer 203, an interlayer insulating layer 205, and a planarization layer 207.

The buffer layer 201 may be located on the substrate 100. The buffer layer 201 may reduce or prevent or reduce infiltration of contaminants such as foreign material, moisture, or ambient air from below the substrate 100 and may provide a flat surface on the substrate 100. The buffer layer 201 may include an inorganic material, such as an oxide or a nitride, an organic material, or an organic/inorganic composite material and may have a single-layer or multilayer structure including an inorganic material and an organic material. A barrier layer that prevents or reduces infiltration of ambient air may be further included between the substrate 100 and the buffer layer 201. For example, the buffer layer 201 may include silicon oxide or silicon nitride.

The thin-film transistor TFT may be located on the buffer layer 201. The thin-film transistor TFT may include a semiconductor layer ACT, a gate electrode GE, a source electrode SE, and a drain electrode DE. The thin-film transistor TFT may be connected to an organic light-emitting diode and configured to drive the organic light-emitting diode.

The semiconductor layer ACT may be located on the buffer layer 201. The semiconductor layer ACT may include polysilicon or amorphous silicon. Alternatively, the semiconductor layer ACT may include an oxide of at least one selected from indium (In), gallium (Ga), stannum (Sn), zirconium (Zr), vanadium (V), hafnium (Hf), cadmium (Cd), germanium (Ge), chromium (Cr), titanium (Ti), and zinc (Zn). The semiconductor layer ACT may include a channel region, and a source region and a drain region doped with impurities.

Each of the gate electrode GE, the source electrode SE, and the drain electrode DE may include various conductive materials. According to some embodiments, the gate electrode GE may include at least one of molybdenum (Mo), aluminum (Al), copper (Cu), or titanium (Ti). For example, the gate electrode GE may be a single molybdenum (Mo) layer, or may have a three-layer structure including a molybdenum (Mo) layer, an aluminum (Al) layer, and a molybdenum (Mo) layer. According to some embodiments, each of the source electrode SE and the drain electrode DE may include at least one material selected from copper (Cu), titanium (Ti), and aluminum (Al). For example, each of the source electrode SE and the drain electrode DE may have a three-layer structure including a titanium (Ti) layer, an aluminum (Al) layer, and a titanium (Ti) layer.

To ensure insulation between the semiconductor layer ACT and the gate electrode GE, the gate insulating layer 203 may be located between the semiconductor layer ACT and the gate electrode GE. The interlayer insulating layer 205 may be located on the gate electrode GE, and the source electrode SE and the drain electrode DE may be located on the interlayer insulating layer 205.

Each of the gate insulating layer 203 and the interlayer insulating layer 205 may include an inorganic material, such as silicon oxide, silicon nitride, and/or silicon oxynitride. Each of the gate insulating layer 203 and the interlayer insulating layer 205 may be formed by, for example, chemical vapor deposition (CVD) or atomic layer deposition (ALD).

The planarization layer 207 may be located on the thin-film transistor TFT. To provide a flat top surface, after the planarization layer 207 is formed, chemical mechanical polishing may be performed on the top surface of the planarization layer 207. The planarization layer 207 may include general-purpose polymer (e.g., photosensitive polyimide, polyimide, polystyrene (PS), polycarbonate (PC), benzocyclobutene (BCB), hexamethyldisiloxane (HMDSO), polymethylmethacrylate (PMMA), etc.), polymer derivatives having a phenol group, acryl-based polymer, imide-based polymer, aryl ether-based polymer, amide-based polymer, fluorine-based polymer, p-xylene-based polymer, or vinyl alcohol-based polymer. In FIG. 4, the planarization layer 207 is illustrated as a single layer, but according to some embodiments, the planarization layer 207 may be a multilayer. Sub-pixel electrodes 210G, 210B, and 210R of first to third organic light-emitting diodes OLED1, OLED2, and OLED3 may be electrically connected to the thin-film transistors TFT through contact holes of the planarization layer 207, respectively.

The light-emitting diode layer may be located on the sub-pixel circuit layer. According to some embodiments, the light-emitting diode layer may include the first to third organic light-emitting diodes OLED1, OLED2, and OLED3, a first bank layer 225, and spacers 227.

The first to third organic light-emitting diodes OLED1, OLED2, and OLED3 may be located on the sub-pixel circuit layer. The first organic light-emitting diode OLED1 may include a stacked structure of the sub-pixel electrode 210G, an intermediate layer 220G, and an opposite electrode 230, wherein the intermediate layer 220G may include a first common layer 221, an emission layer 222G, and a second common layer 223. The second organic light-emitting diode OLED2 may include a stacked structure of the sub-pixel electrode 210B, an intermediate layer 220B, and the opposite electrode 230, wherein the intermediate layer 220B may include the first common layer 221, an emission layer 222B, and the second common layer 223. The third organic light-emitting diode OLED3 may include a stacked structure of the sub-pixel electrode 210R, an intermediate layer 220R, and the opposite electrode 230, wherein the intermediate layer 220R may include the first common layer 221, an emission layer 222R, and the second common layer 223.

The sub-pixel electrodes 210G, 210B, and 210R may be located on the planarization layer 207. The sub-pixel electrodes 210G, 210B, and 210R may be spaced apart from each other. Each of the sub-pixel electrodes 210G, 210B, and 210R may be a reflection electrode. Each of the sub-pixel electrodes 210G, 210B, and 210R may include a reflection layer and a transparent or semitransparent electrode layer located on the reflection layer. The reflection layer may include silver (Ag), magnesium (Mg), aluminum (Al), platinum (Pt), palladium (Pd), gold (Au), nickel (Ni), neodymium (Nd), iridium (Ir), chromium (Cr), or any compound thereof. The transparent or semitransparent electrode layer may include at least one material selected from indium tin oxide (ITO), indium zinc oxide (IZO), zinc oxide (ZnO), indium oxide (In₂O₃), indium gallium oxide (IGO), or aluminum zinc oxide (AZO).

The first bank layer 225 may be located on the sub-pixel electrodes 210G, 210B, and 210R. The bank layer 225 may have first to third lower openings 225OP1, 225OP2, and 2225OP3 respectively overlapping the sub-pixel electrodes 210G, 210B, and 210R and exposing the central portions of the sub-pixel electrodes 210G, 210B, and 210R. The bank layer 225 may cover the edges of the sub-pixel electrodes 210G, 210B, and 210R and may prevent or reduce an electric arc or the like occurring on the edges of the sub-pixel electrodes 210G, 210B, and 210R by increasing the distance between the edge of each of the sub-pixels 210G, 210B, and 210R and the opposite electrode 230.

The first to third lower openings 225OP1, 225OP2, and 225OP3 of the bank layer 225 may respectively define emission areas EA1, EA2, and EA3 of the first to third organic light-emitting diodes OLED1, OLED2, and OLED3 included in each sub-pixel. As illustrated in FIG. 4, the first bank layer 225 may include the first lower opening 225OP1 defining the emission area EA1 of the first organic light-emitting diode OLED1 of the first color sub-pixel. In addition, the bank layer 225 may include the second lower opening 225OP2 defining the emission area EA2 of the second organic light-emitting diode OLED2 of the second color sub-pixel, and may include the third lower opening 225OP3 defining the emission area EA3 of the third organic light-emitting diode OLED3 of the third color sub-pixel.

The first bank layer 225 may include an organic insulating material. Alternatively, the first bank layer 225 may include an inorganic insulating material, such as silicon nitride or silicon oxide. According to some embodiments, the first bank layer 225 may include an organic insulating material and an inorganic insulating material.

According to some embodiments, the first bank layer 225 may include a light-blocking material. For example, the light-blocking material of the first bank layer 225 may be black. The light-blocking material may include carbon black, carbon nanotubes, a resin or paste including black dye, metal particles (e.g., nickel, aluminum, molybdenum, any alloy thereof, etc.), metal oxide particles, or metal nitride particles. When the first bank layer 225 includes a light-blocking material, the reflection of external light due to the metal structures below the first bank layer 225 may be reduced.

The spacer 227 may be located on the first bank layer 225. The spacer 227 may include an organic insulating material, such as polyimide. Alternatively, the spacer 227 may include an inorganic insulating material, such as silicon nitride or silicon oxide, or may include an organic insulating material and an inorganic insulating material. According to some embodiments, the spacer 227 may include a material that is different than a material of the first bank layer 225 including the light-blocking material described above, and may be formed in a separate process.

According to some embodiments, the spacer 227 may include the same material as the material of the first bank layer 225. In this case, the first bank layer 225 and the spacer 227 may be formed together in a mask process using a half-tone mask or the like.

The intermediate layer may be located on the sub-pixel electrodes 210G, 210B, and 210R and the first bank layer 225. As described above, the intermediate layer may include the first common layer 221, the emission layer, and the second common layer 223.

The emission layers 222G, 222B, and 222R may be respectively located inside the first to third lower openings 225OP1, 225OP2, and 225OP3 of the first bank layer 225. Each of the emission layers 222G, 222B, and 222R may be an organic material including a fluorescent or phosphorescent material capable of emitting red light, green light, or blue light. The organic material described above may include a low molecular weight organic material or a high molecular weight organic material.

The first common layer 221 and the second common layer 223 may be respectively located below and above the emission layer. For example, the first common layer 221 may include a hole transport layer (HTL), or may include an HTL and a hole injection layer (HIL). For example, the second common layer 223 may include an electron transport layer (ETL), or may include an ETL and an electron injection layer (EIL). According to some embodiments, the second common layer 223 may not be provided.

While the emission layers 222G, 222B, and 222R are respectively arranged for the sub-pixels to correspond to the first to third lower openings 225OP1, 225OP2, and 225OP3 of the first bank layer 225, the first common layer 221 and the second common layer 223 may be integrally formed to completely cover the substrate 100. In other words, the first common layer 221 and the second common layer 223 may be integrally formed to completely cover the display area DA of the substrate 100.

The opposite electrode 230 may be a cathode that is an electron injection electrode. The opposite electrode 230 may include a conductive material having a low work function. For example, the opposite electrode 230 may include a (semi)transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or any alloy thereof. Alternatively, the opposite electrode 230 may further include a layer including ITO, IZO, ZnO, or In₂O₃ on the (semi)transparent layer including the material described above.

According to some embodiments, a capping layer 240 may be further located on the display layer 200. The capping layer 240 may be located on the first to third organic light-emitting diodes OLED1, OLED2, and OLED3. According to some embodiments, the capping layer 240 may relatively improve the light emission efficiency of the first to third organic light-emitting diodes OLED1, OLED2, and OLED3 by the principle of constructive interference.

The capping layer 240 may be an organic capping layer including an organic material, an inorganic capping layer including an inorganic material, or a composite capping layer including an organic material and an inorganic material. For example, the capping layer 240 may include a carbocyclic compound, a heterocyclic compound, an amine group-containing compound, porphine derivatives, phthalocyanine derivatives, naphthalocyanine derivatives, an alkali metal complex, an alkaline earth metal complex, or any combination thereof. The carbocyclic compound, the heterocyclic compound, and the amine group-containing compound may be optionally substituted with a substituent including O, N, S, Se, Si, F, Cl, Br, I, or any combination thereof.

The encapsulation layer 400 may be located on the capping layer 240. The encapsulation layer 400 may include at least one inorganic encapsulation layer and at least one organic encapsulation layer. For example, as illustrated in FIG. 4, the encapsulation layer 400 may include a first inorganic encapsulation layer 410, an organic encapsulation layer 420, and a second inorganic encapsulation layer 430, which are sequentially stacked in this stated order.

Each of the first inorganic encapsulation layer 410 and the second inorganic encapsulation layer 430 may include an inorganic insulating material, such as silicon oxide, silicon nitride, silicon oxynitride, aluminum oxide, titanium oxide, tantalum oxide, hafnium oxide, or zinc oxide. Each of the first inorganic encapsulation layer 410 and the second inorganic encapsulation layer 430 may have a single-layer or multilayer structure including the inorganic insulating material described above.

The organic encapsulation layer 420 may relieve internal stress of the first inorganic encapsulation layer 410 and/or the second inorganic encapsulation layer 430. The organic encapsulation layer 420 may include a polymer-based material. For example, the organic encapsulation layer 420 may include polyethylene terephthalate, polyethylene naphthalate, polycarbonate, polyimide, polyethylene sulfonate, polyoxymethylene, polyarylate, hexamethyldisiloxane, acryl resin (e.g., polymethylmethacrylate, polyacrylic acid, etc.), or any combination thereof.

The encapsulation layer 400 may have a multilayer structure including the first inorganic encapsulation layer 410, the organic encapsulation layer 420, and the second inorganic encapsulation layer 430. In this case, even when cracks occur in the encapsulation layer 400, the cracks may not propagate between the first inorganic encapsulation layer 410 and the organic encapsulation layer 420 or between the organic encapsulation layer 420 and the second inorganic encapsulation layer 430. The encapsulation layer 400 may prevent, reduce, or minimize infiltration of ambient moisture or oxygen into the display area DA.

The touch sensor layer 500 may be located on the encapsulation layer 400. The touch sensor layer 500 may include a first touch electrode MT1, a first touch insulating layer 510, a second touch electrode MT2, and a second touch insulating layer 520. The first touch electrode MT1 may be located directly on the encapsulation layer 400. For example, the first touch electrode MT1 may be located directly on the second inorganic encapsulation layer 430 of the encapsulation layer 400. However, the disclosure is not necessarily limited thereto.

According to some embodiments, the touch sensor layer 500 may include an insulating layer between the first touch electrode MT1 and the encapsulation layer 400. In this case, the insulating layer may be located on the second inorganic encapsulation layer 430 of the encapsulation layer 400 to planarize the surface on which the first touch electrode MT1 or the like is located. The insulating layer may include an inorganic insulating material, such as silicon oxide, silicon nitride, or silicon oxynitride. According to some embodiments, the insulating layer may include an organic insulating material.

The first touch insulating layer 510 may be located on the first touch electrode MT1. The first touch insulating layer 510 may include an inorganic material or an organic material. When the first touch insulating layer 510 includes an inorganic material, the first touch insulating layer 510 may include at least one material selected from silicon nitride, aluminum nitride, zirconium nitride, titanium nitride, hafnium nitride, tantalum nitride, silicon oxide, aluminum oxide, titanium oxide, tin oxide, cerium oxide, and silicon oxynitride. When the first touch insulating layer 510 includes an organic material, the first touch insulating layer 510 may include at least one material selected from acryl-based resin, methacrylic-based resin, polyisoprene, vinyl-based resin, epoxy-based resin, urethane-based resin, cellulose-based resin, and perylene-based resin.

The second touch electrode MT2 may be located on the first touch insulating layer 510. The second touch electrode MT2 may act as a sensor configured to sense a touch input of a user. The first touch electrode MT1 may act as a connection portion that connects the patterned second touch electrodes MT2 to each other in one direction. According to some embodiments, both the first touch electrode MT1 and the second touch electrode MT2 may act as sensors. In this case, the first touch electrode MT1 and the second touch electrode MT2 may be electrically connected to each other through a contact hole. When both the first touch electrode MT1 and the second touch electrode MT2 act as sensors, the resistance of the touch electrodes may be reduced, allowing the touch input of the user to be sensed quickly.

According to some embodiments, the first touch electrode MT1 and the second touch electrode MT2 may have a structure capable of transmitting light emitted from the organic light-emitting diode, for example, a mesh structure. In this case, the first touch electrode MT1 and the second touch electrode MT2 may be arranged not to overlap the emission area of the organic light-emitting diode.

Each of the first touch electrode MT1 and the second touch electrode MT2 may include a metal layer or a transparent conductive layer. The metal layer may include molybdenum (Mo), silver (Ag), titanium (Ti), copper (Cu), aluminum (Al), or any alloy thereof. The transparent conductive layer may include a transparent conductive oxide (e.g., ITO, IZO, ZnO, indium tin zinc oxide (ITZO), etc.), conductive polymer (e.g., poly-(3,4)-ethylene-dihydroxy thiophene (PEDOT)), metal nanowires, carbon nanotubes, or graphene.

The second touch insulating layer 520 may be located on the second touch electrode MT2. The second touch insulating layer 520 may include an inorganic material or an organic material. When the second touch insulating layer 520 includes an inorganic material, the second touch insulating layer 520 may include at least one material selected from silicon nitride, aluminum nitride, zirconium nitride, titanium nitride, hafnium nitride, tantalum nitride, silicon oxide, aluminum oxide, titanium oxide, tin oxide, cerium oxide, and silicon oxynitride. When the second touch insulating layer 520 includes an organic material, the second touch insulating layer 520 may include at least one material selected from acryl-based resin, methacrylic-based resin, polyisoprene, vinyl-based resin, epoxy-based resin, urethane-based resin, cellulose-based resin, and perylene-based resin.

According to some embodiments, the touch sensor layer 500 may include the first touch electrode MT1, the first touch insulating layer 510, and the second touch electrode MT2, but may not include the second touch insulating layer 520. In this case, the anti-reflection layer 600 may be provided in a structure that covers the second touch electrode MT2.

The anti-reflection layer 600 may be located on the touch sensor layer 500.

Referring to FIG. 4, the anti-reflection layer 600 may include a second bank layer 610, a light control layer 620, and color filters. According to some embodiments, the anti-reflection layer 600 may include first to third color filters 630G, 630B, and 630R of different colors respectively corresponding to the first to third organic light-emitting diodes OLED1, OLED2, and OLED3. Each of the first to third color filters 630G, 630B, and 630R may be provided in plurality.

The anti-reflection layer 600 may be located on the touch sensor layer 500. The anti-reflection layer 600 may be located directly on the touch sensor layer 500, for example, the second touch insulating layer 520 corresponding to the uppermost portion of the touch sensor layer 500. The second bank layer 610, the light control layer 620, and the color filters, which constitute the anti-reflection layer 600, may be located directly on the touch sensor layer 500.

The second bank layer 610 may have first to third upper openings 610OP1, 610OP2, and 610OP3 respectively corresponding to the first to third color sub-pixels. The second bank layer 610 may include the first upper opening 610OP1 corresponding to the emission area EA1, the second upper opening 610OP2 corresponding to the emission area EA2, and the third upper opening 610OP3 corresponding to the emission area EA3. Pieces of light (or light) emitted from the first to third organic light-emitting diodes OLED1, OLED2, and OLED3 may be respectively emitted to the outside through the first to third upper openings 610OP1, 610OP2, and 610OP3 of the second bank layer 610.

The first upper opening 610OP1 of the second bank layer 610 may overlap the first lower opening 225OP1 of the first bank layer 225, the second upper opening 610OP2 may overlap the second lower opening 225OP2, and the third upper opening 610OP3 may overlap the third lower opening 225OP3.

As used herein, the width (or size) of each sub-pixel may refer to the width (or size) of the emission area of the organic light-emitting diode implementing each sub-pixel, and the width (or size) of the emission area may be defined by the width (or size) of the lower opening provided in the first bank layer 225.

According to some embodiments, the width (or size) of each of the first to third upper openings 610OP1, 610OP2, and 610OP3 of the second bank layer 610 may be greater than the width (or size) of the corresponding sub-pixel among the first to third color sub-pixels. That is, the width (or size) of each of the first to third upper openings 610OP1, 610OP2, and 610OP3 of the second bank layer 610 may be greater than the width (or size) of each of the first to third lower openings 225OP1, 225OP2, and 225OP3 of the first bank layer 225.

According to some embodiments, the width (or size) of each of the first to third upper openings 610OP1, 610OP2, and 610OP3 of the second bank layer 610 may be substantially equal to the width (or size) of the corresponding sub-pixel among the first to third color sub-pixels. That is, the width (or size) of each of the first to third upper openings 610OP1, 610OP2, and 610OP3 of the second bank layer 610 may be substantially equal to the width (or size) of each of the first to third lower openings 225OP1, 225OP2, and 225OP3 of the first bank layer 225.

The second bank layer 610 may include an organic insulating material. Alternatively, the second bank layer 610 may include an inorganic insulating material, such as silicon nitride or silicon oxide. According to some embodiments, the second bank layer 610 may include an organic insulating material and an inorganic insulating material.

According to some embodiments, the second bank layer 610 may include a light-blocking material. For example, the light-blocking material of the second bank layer 610 may be black. The light-blocking material may include carbon black, carbon nanotubes, a resin or paste including black dye, metal particles (e.g., nickel, aluminum, molybdenum, and any alloy thereof), metal oxide particles, or metal nitride particles. When the second bank layer 610 includes a light-blocking material, the reflection of external light due to the metal structures below the second bank layer 610 may be reduced.

The light control layer 620 may include light control patterns spaced apart from each other to correspond to each sub-pixel. The light control patterns may include a first light control pattern 621 corresponding to the first color sub-pixel, a second light control pattern 622 corresponding to the second color sub-pixel, and a third light control pattern 623 corresponding to the third color sub-pixel. In other words, the light control layer 620 may include the first light control pattern 621 corresponding to the emission area EA1 of the first organic light-emitting diode OLED1, the second light control pattern 622 corresponding to the emission area EA2 of the second organic light-emitting diode OLED2, and the third light control pattern 623 corresponding to the emission area EA3 of the third organic light-emitting diode OLED3. Each of the first to third light control patterns 621, 622, and 623 may be provided in plurality.

In the light control layer 620, the first light control pattern 621 may overlap the first lower opening 225OP1 of the first bank layer 225, the second light control pattern 622 may overlap the second lower opening 225OP2, and the third light control pattern 623 may overlap the third lower opening 225OP3.

The first to third light control patterns 621, 622, and 623 of the light control layer 620 may be respectively located in the emission areas of the corresponding sub-pixels. The first light control pattern 621 may be located in the emission area EA1, the second light control pattern 622 may be located in the emission area EA2, and the third light control pattern 623 may be located in the emission area EA3.

The width (or size) of each of the first to third light control patterns 621, 622, and 623 of the light control layer 620 may be less than the width (or size) of the corresponding sub-pixel among the first to third color sub-pixels. That is, the width (or size) of the first light control pattern 621 of the light control layer 620 may be less than the width (or size) of the first lower opening 225OP1 of the corresponding first bank layer 225. The width (or size) of the second light control pattern 622 of the light control layer 620 may be less than the width (or size) of the second lower opening 225OP2 of the corresponding first bank layer 225. The width (or size) of the third light control pattern 623 of the light control layer 620 may be less than the width (or size) of the third lower opening 225OP3 of the corresponding first bank layer 225.

The first to third light control patterns 621, 622, and 623 may be located on the same layer as the second bank layer 610. The first to third light control patterns 621, 622, and 623 and the second bank layer 610 may be located on the touch sensor layer 500, for example, the second touch insulating layer 520.

The first to third light control patterns 621, 622, and 623 of the light control layer 620 may be respectively located in the first to third upper openings 610OP1, 610OP2, and 610OP3 of the second bank layer 610. The first to third light control patterns 621, 622, and 623 may be spaced apart from (a body portion of) the second bank layer 610.

The width (or size) of the first light control pattern 621 may be less than the width (or size) of the first upper opening 610OP1 of the corresponding second bank layer 610. The width (or size) of the second light control pattern 622 may be less than the width (or size) of the second upper opening 610OP2 of the corresponding second bank layer 610. The width (or size) of the third light control pattern 623 may be less than the width (or size) of the third upper opening 610OP3 of the corresponding second bank layer 610.

According to some embodiments, each of the light control patterns of the light control layer 620 may include a scattering pattern. When each of the light control patterns of the light control layer 620 includes a scattering pattern, the light control patterns may include scattering particles for scattering at least a portion of light incident on the light control layer 620. The scattering particles may include metal oxide, such as TiO₂. The size of the scattering particles may be 200 nm or more. The scattering particles may have a surface roughness of 50 nm or more so as to facilitate reflection and/or scattering of light from the surface. According to some embodiments, each of the light control patterns of the light control layer 620 may include an organic insulating material, such as polyimides resin, acryl resin, or BCB, in which scattering particles are dispersed.

In FIGS. 4 to 17, it is assumed that the light control patterns of the light control layer 620 are provided as scattering patterns. However, the disclosure is not necessarily limited thereto. According to some embodiments, each of the light control patterns of the light control layer 620 may include a scattering pattern and a light-blocking pattern located on the scattering pattern.

According to some embodiments, each of the first to third light control patterns 621, 622, and 623 may be formed by a photolithography method.

The color filters may be located on the second bank layer 610 and the light control layer 620.

The first to third color filters 630G, 630B, and 630R may be respectively located in the first to third upper openings 610OP1, 610OP2, and 610OP3 of the second bank layer 610. The first to third color filters 630G, 630B, and 630R may have colors corresponding to pieces of light (or light) emitted from the emission areas EA1, EA2, and EA3. According to some embodiments, when green light is emitted from the emission area EA1, the first color filter 630G may be a green color filter; when blue light is emitted from the emission area EA2, the second color filter 630B may be a blue color filter; and when red light is emitted from the emission area EA3, the third color filter 630R may be a red color filter.

The width (or size) of the first color filter 630G may be greater than the width (or size) of the first upper opening 610OP1 of the corresponding second bank layer 610. The width (or size) of the second color filter 630B may be greater than the width (or size) of the second upper opening 610OP2 of the corresponding second bank layer 610. The width (or size) of the third color filter 630R may be greater than the width (or size) of the third upper opening 610OP3 of the corresponding second bank layer 610.

Referring to FIGS. 4 and 5, the first to third color filters 630G, 630B, and 630R may respectively cover the first to third light control patterns 621, 622, and 623. That is, the first color filter 630G may cover a top surface 621t and a side surface 621s of the first light control pattern 621 located in the first upper opening 610OP1 of the second bank layer 610. Similarly, the second color filter 630B may cover a top surface and a side surface of the second light control pattern 622 located in the second upper opening 610OP2 of the second bank layer 610. The third color filter 630R may cover a top surface and a side surface of the third light control pattern 623 located in the third upper opening 610OP3 of the second bank layer 610.

According to some embodiments, in a plan view, the width of each of the light control patterns of the light control layer 620 may be about 1 µm to about 5 µm.

According to some embodiments, the thickness of each of the light control patterns of the light control layer 620 may be about 1 µm to about 2 µm.

A thickness t1 of the second bank layer 610 may be greater than a thickness of each of the light control patterns of the light control layer 620. When the thickness t1 of the second bank layer 610 is less than the thickness of each of the light control patterns of the light control layer 620, it may be difficult to form the first to third color filters 630G, 630B, and 630R on the second bank layer 610.

As illustrated in FIG. 5, the thickness t1 of the second bank layer 610 may be greater than a thickness t2 of the first light control pattern 621 of the light control layer 620. The first color filter 630G may be located on a portion of the top surface of the second bank layer 610. The first color filter 630G may include a first portion PT1 located on the first light control pattern 621 and a second portion PT2 that does not overlap the first light control pattern 621. The second portion PT2 may be a portion that comes into contact with the touch sensor layer 500, for example, the second touch insulating layer 520. According to some embodiments, a thickness ta of the first portion PT1 of the first color filter 630G may be less than a thickness tb of the second portion PT2. In FIG. 5, the first light control pattern 621 and the first color filter 630G of the light control layer 620 are described as an example, but the same description may be applied to the second light control pattern 622 and the second color filter 630B and to the third light control pattern 623 and the third color filter 630R.

The anti-reflection layer 600 may further include an overcoat layer 640. The overcoat layer 640 may be located on the second bank layer 610 and/or the first to third color filters 630G, 630B, and 630R. The overcoat layer 640 may planarize the top surfaces of the second bank layer 610 and/or the first to third color filters 630G, 630B, and 630R. The overcoat layer 640 may be a colorless, light-transmitting layer that does not have a color in a visible light band. The overcoat layer 640 may include a colorless, light-transmitting organic material, such as acryl-based resin.

The cover window 700 may be located on the overcoat layer 640 with an adhesive layer OCA therebetween.

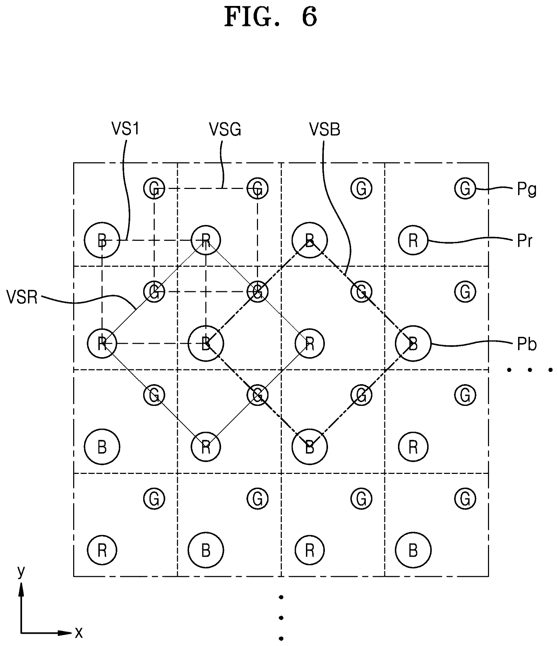

FIG. 6 is a plan view illustrating a layout of sub-pixels in a portion of a display apparatus according to some embodiments.

Referring to FIG. 6, the sub-pixels of the display apparatus may include a first color sub-pixel, a second color sub-pixel, and a third color sub-pixel. According to some embodiments, the first color sub-pixel may be a green sub-pixel Pg, the second color sub-pixel may be a blue sub-pixel Pb, and the third color sub-pixel may be a red sub-pixel Pr. Hereinafter, it is assumed that the first color sub-pixel is the green sub-pixel Pg, the second color sub-pixel is the blue sub-pixel Pb, and the third color sub-pixel is the red sub-pixel Pr.

The sub-pixels may have a structure in which red sub-pixels Pr, blue sub-pixels Pb, and green sub-pixels Pg are repeatedly arranged. According to some embodiments, the red sub-pixels Pr and the blue sub-pixels Pb may be located at vertices of a virtual quadrangle VS1 with one green sub-pixel Pg as the center point. The red sub-pixels Pr may be located at opposite vertices with the green sub-pixel Pg therebetween along the diagonal direction of the virtual quadrangle VS1, and the blue sub-pixels Pb may be located at opposite vertices with the green sub-pixel Pg therebetween along the diagonal direction of the virtual quadrangle VS1. In addition, the green sub-pixels Pg may be respectively located on the edges (e.g, at the midpoint of an edge) of the virtual quadrangles VSB and/or on the edges (e.g., at the midpoint of an edge) of the virtual quadrangles VSR with the sub-pixel (the blue sub-pixel Pb or the red sub-pixel Pr) positioned at one vertex of the virtual quadrangle VS1 as the center point. According to some embodiments, each of the virtual quadrangles VS1, VSB, and VSR may have a rectangular shape. For example, each of the virtual quadrangles VS1, VSB, and VSR may have a square shape.

To differently express the layout of the sub-pixels in FIG. 6, the red sub-pixels Pr, the blue sub-pixels Pb, and the green sub-pixels Pg may be located in a PENTILE^{™} structure, for example, a diamond PENTILE^{™} structure. However, the disclosure is not necessarily limited thereto. For example, according to some embodiments, the red sub-pixels Pr, the blue sub-pixels Pb, and the green sub-pixels Pg may be arranged in a stripe structure.

Each of the red sub-pixels Pr, the blue sub-pixels Pb, and the green sub-pixels Pg may have a circular shape. However, the disclosure is not necessarily limited thereto. According to some embodiments, each of the red sub-pixels Pr, the blue sub-pixels Pb, and the green sub-pixels Pg may have an elliptical shape or a polygonal shape. The polygonal shape may include a shape with round vertices. In the present specification, a case where each of the red sub-pixels Pr, the blue sub-pixels Pb, and the green sub-pixels Pg has a circular shape is described.

The red sub-pixel Pr, the blue sub-pixel Pb, and the green sub-pixel Pg having different sizes (or widths) may be provided. For example, the size (or width) of the green sub-pixel Pg may be less than the size (or width) of each of the red sub-pixel Pr and the blue sub-pixel Pb. The size (or width) of the blue sub-pixel Pb may be greater than the size (or width) of the red sub-pixel Pr. According to some embodiments, various modifications may be made thereto. For example, the sizes of the red sub-pixel Pr, the blue sub-pixel Pb, and the green sub-pixel Pg may be substantially equal to each other.

In the sub-pixel layout structure of FIG. 6, the adjacent green sub-pixels Pg may be located at the vertices of the virtual quadrangle VSG with the red sub-pixel Pr or the blue sub-pixel Pb as the center point. The virtual quadrangle VSG may be a rectangle. For example, the virtual quadrangle VSG may be a square. The adjacent blue sub-pixels Pb may be located at vertices of the virtual quadrangle VSB with the red sub-pixel Pr as the center point. The adjacent red sub-pixels Pr may be located at vertices of the virtual quadrangle VSR with the blue sub-pixel Pb as the center point. For example, two adjacent green sub-pixels Pg may be arranged in the x direction or the y direction. Two adjacent blue sub-pixels Pb may be arranged in a diagonal direction tilted with respect to the x direction or the y direction. Two adjacent red sub-pixels Pr may be arranged in a diagonal direction tilted with respect to the x direction or the y direction. Two adjacent blue sub-pixels Pb may be arranged in a direction tilted at 45° with respect to the x direction or the y direction. Two adjacent red sub-pixels Pr may be arranged in a direction tilted at 45° with respect to the x direction or the y direction.

Referring to FIG. 4, the display apparatus 10 of the disclosure may include the second bank layer 610, the light control layer 620, and the anti-reflection layer 600 including color filters. Compared to a display apparatus including a polarizing film arranged on an entire surface of a substrate, the display apparatus 10 including the second bank layer 610 and the color filters instead of the polarizing film may have excellent light efficiency and may increase external light reflection, for example, external light reflection by each sub-pixel (e.g., the sub-pixel electrode or the opposite electrode of each sub-pixel). Furthermore, interference patterns caused by diffraction of light reflected from each sub-pixel of the display apparatus 10 may increase.

However, the display apparatus 10 according to some embodiments may include light control patterns having an area (or size) in a certain range, and the light control patterns respectively corresponding to two adjacent sub-pixels among the sub-pixels of the same color may be located at different positions with respect to the center of each sub-pixel. Each of the light control patterns may include a scattering pattern. Accordingly, the display apparatus 10 may have relatively improved display quality and reduced interference patterns due to external light reflection and diffraction.

For example, the light control patterns respectively corresponding to two adjacent sub-pixels among the sub-pixels of the same color, which are included in the display apparatus 10 according to some embodiments, may be located at different positions in at least one of a first direction or a second direction perpendicular to the first direction with respect to the center of each sub-pixel. Each of the light control patterns included in the display apparatus 10 according to some embodiments may have an area (or size) of 10 % to 80 % of the area (or size) of the emission area of the corresponding sub-pixel among the sub-pixels.

The display apparatus 10 according to some embodiments may reduce interference patterns formed by reflected and/or scattered lights and relatively improve a side viewing angle by arranging the light control patterns at different positions so that conditions for reflected and/or scattered light in the adjacent sub-pixels of the same color change. At the same time, the light emission efficiency of the display apparatus may be relatively improved by optimizing or improving the areas of the light control patterns.

The area (or size) of the emission area of the sub-pixel may be equal to the area (or size) of the lower opening provided in the first bank layer 225. The area (or size) of the lower opening of the first bank layer 225 may be the area (or size) of the edge of the inner surface of the first bank layer 225 forming the lower opening. The edge of the inner surface of the first bank layer 225 forming the lower opening may refer to the boundary of a portion of the sub-pixel electrode exposed by the lower opening.

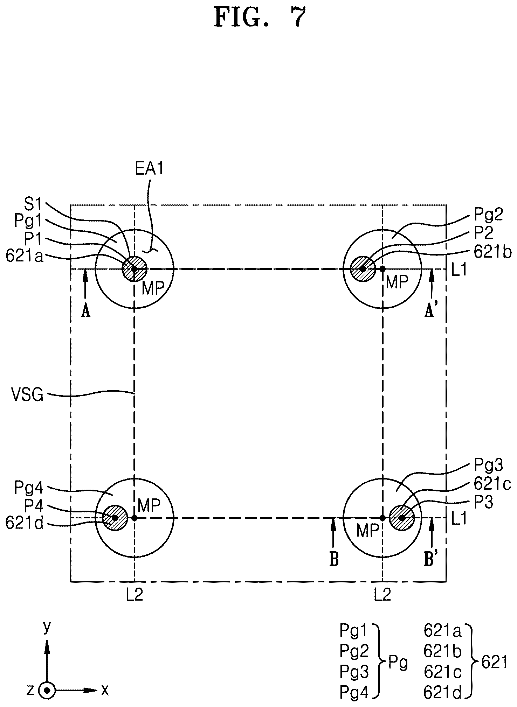

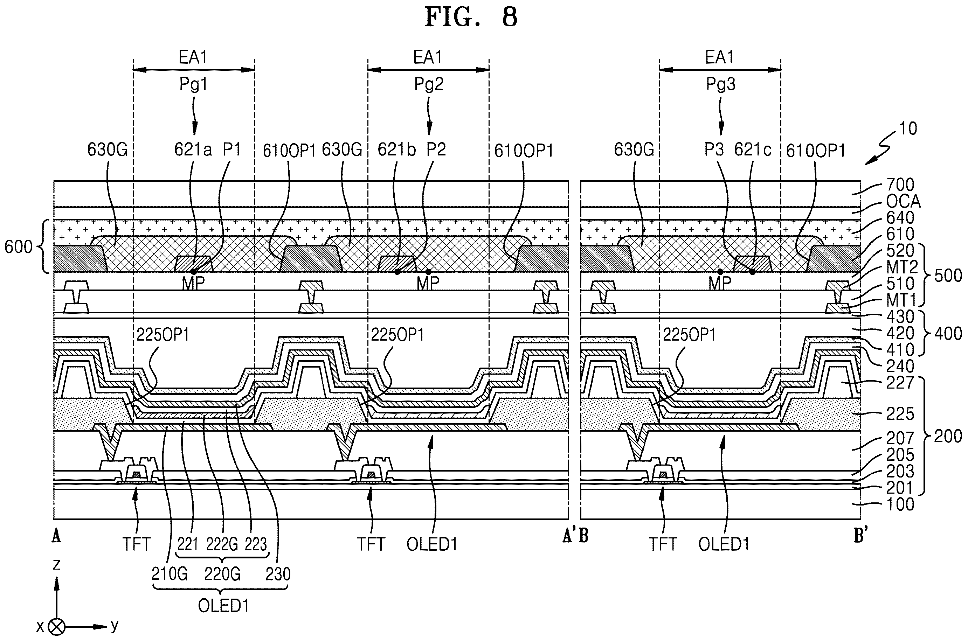

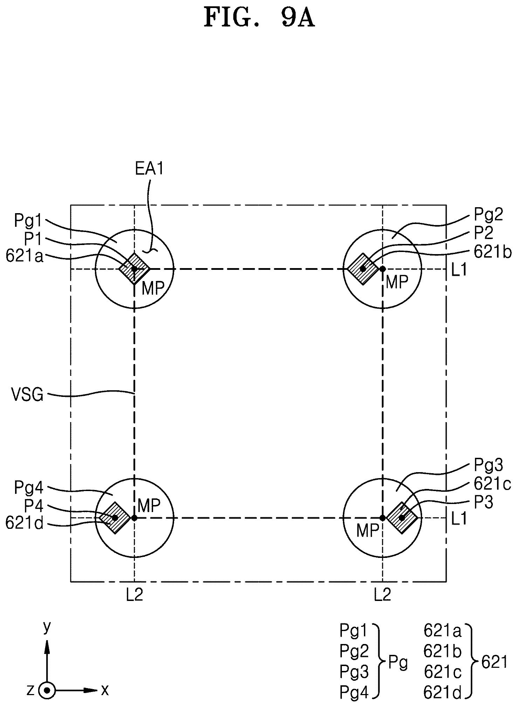

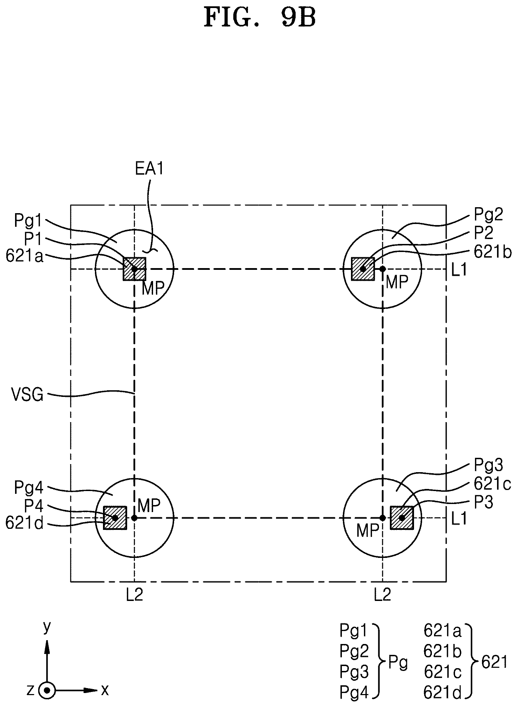

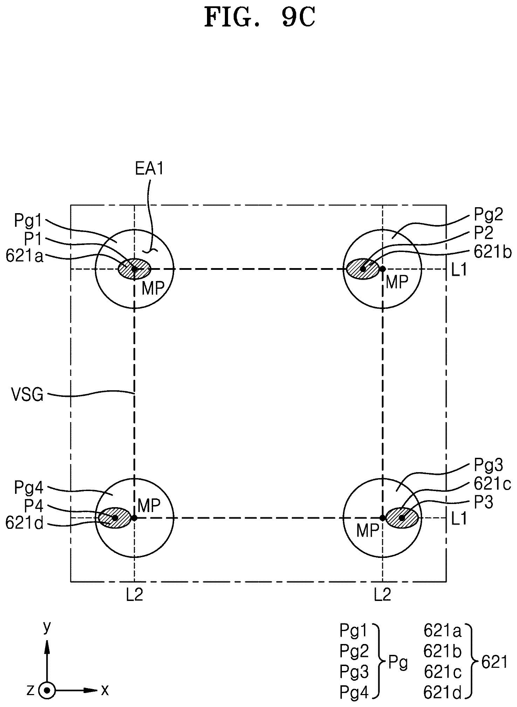

FIG. 7 is a plan view illustrating some sub-pixels and light control patterns corresponding thereto in a display apparatus according to some embodiments. FIG. 7 illustrates an example of light control patterns that may be arranged to correspond to the respective green sub-pixels by extracting some green sub-pixels among the sub-pixels illustrated in FIG. 6. FIG. 8 is a cross-sectional view schematically illustrating a portion of the display apparatus taken along the lines A-A' and B-B' of FIG. 7, according to some embodiments. FIGS. 9A, 9B, and 9C are plan views illustrating some sub-pixels and light control patterns corresponding thereto in a display apparatus according to some embodiments. FIGS. 9A to 9C illustrate modifications of FIG. 7.

In FIG. 7 and FIGS. 9A to 13, 15, and 21 described below, L1 represents an imaginary line extending in a first direction (e.g., a -x direction or an +x direction) and passing through the center MP of the sub-pixel, and L2 represents an imaginary line extending in a second direction (e.g., a -y direction or a +y direction) and passing through the center MP of the sub-pixel. L1 and L2 are illustrated for convenience to help understanding.

Referring to FIGS. 7 and 8, the green sub-pixels Pg of the display apparatus 10 may include a first green sub-pixel Pg1, a second green sub-pixel Pg2, a third green sub-pixel Pg3, and a fourth green sub-pixel Pg4, which are located at vertices of a virtual quadrangle VSG. The first green sub-pixel Pg1 and the second green sub-pixel Pg2 may be located adjacent to each other, the second green sub-pixel Pg2 and the third green sub-pixel Pg3 may be located adjacent to each other, the third green sub-pixel Pg3 and the fourth green sub-pixel Pg4 may be located adjacent to each other, and the first green sub-pixel Pg1 and the fourth green sub-pixel Pg4 may be located adjacent to each other.

Hereinafter, based on the sub-pixel layout structure of FIG. 6, the sub-pixels located at the shortest distance among the first to fourth green sub-pixels Pg1, Pg2, Pg3, and Pg4 located in the virtual quadrangle VSG are described as adjacent sub-pixels.

First light control patterns 621 may include first-1 to first-4 light control patterns 621a, 621b, 621c, and 621d respectively corresponding to the first to fourth green sub-pixels Pg1, Pg2, Pg3, and Pg4. The first-1 light control pattern 621a may be located in an emission area EA1 of the first green sub-pixel Pg1. The first-2 light control pattern 621b may be located in an emission area EA1 of the second green sub-pixel Pg2. The first-3 light control pattern 621c may be located in an emission area EA1 of the third green sub-pixel Pg3. The first-4 light control pattern 621d may be located in an emission area EA1 of the fourth green sub-pixel Pg4.

In a plan view, each of the first light control patterns 621 may have an area S1 corresponding to 10 % to 80 % of the area of the emission area EA1 of the corresponding green sub-pixel Pg. For example, each of the first light control patterns 621 may have an area S1 corresponding to 20 % to 75 % of the area of the emission area EA1 of the corresponding green sub-pixel Pg. For example, each of the first light control patterns 621 may have an area S1 corresponding to 25 % to 50 % of the area of the emission area EA1 of the corresponding green sub-pixel Pg. When the area S1 of each of the first light control patterns 621 is less than 10 % with respect to the area of the emission area EA1 of the green sub-pixel Pg, the effect of relatively improving the interference pattern by the light control patterns may be minimal. On the other hand, when the area S1 of each of the first light control patterns 621 is greater than 80 % with respect to the area of the emission area EA1 of the green sub-pixel Pg, the light emission efficiency of the display apparatus may decrease.

According to some embodiments, the first light control patterns 621 may have the same size (or area). For example, the first-1 to first-4 light control patterns 621a to 621d may have the same size (or area).

According to some embodiments, each of the first light control patterns 621 may have a circular shape. However, the disclosure is not necessarily limited thereto. According to some embodiments, as illustrated in FIGS. 9A and 9B, each of the first light control patterns 621 may have a polygonal shape, including a rectangular shape or a diamond shape. Alternatively, as illustrated in FIG. 9C, each of the first light control patterns 621 may have an elliptical shape. Each of the first light control patterns 621 may have various shapes according to the design of the sub-pixel, such as the shape of the sub-pixel. For convenience of explanation, the first light control patterns 621 have been described as an example with reference to FIGS. 9A to 9C, but the second light control patterns 622 and the third light control patterns 623 may also have various shapes, such as a circular shape, a polygonal shape such as a rectangular shape or an elliptical shape.

In a plan view, the first light control patterns 621 located on two adjacent green sub-pixels Pg may be located at different positions in at least one of the first direction (e.g., the -x direction or the +x direction) or the second direction (e.g., the -y direction or the +y direction) perpendicular to the first direction (e.g., the -x direction or the +x direction) with respect to the center of the corresponding green sub-pixel Pg.

As used herein, the expression "in a plan view, the light control patterns are located at different positions in at least one of the first direction or the second direction with respect to the center of the corresponding sub-pixel" means that, in a plan view, the centers of the light control patterns are located at different positions in at least one of the first direction or the second direction with respect to the center of the corresponding sub-pixel within the corresponding sub-pixel. The center of the component (the sub-pixel or the light control pattern) refers to the center (center of gravity) of the planar shape of the component (the sub-pixel or the light control pattern).

Referring to FIGS. 7 and 8, according to some embodiments, in a plan view, the first-1 light control pattern 621a and the first-2 light control pattern 621 b may be located at different positions in the first direction (e.g., the -x direction or the +x direction) with respect to the center MP of the corresponding green sub-pixel Pg. The center P1 of the first-1 light control pattern 621a and the center P2 of the first-2 light control pattern 621b may be located at different positions in the first direction (e.g., the -x direction or the +x direction). The first-2 light control pattern 621b and the first-3 light control pattern 621c may be located at different positions in the first direction (e.g., the -x direction or the +x direction) with respect to the center MP of the corresponding green sub-pixel Pg. The center P2 of the first-2 light control pattern 621b and the center P3 of the first-3 light control pattern 621c may be located at different positions in the first direction (e.g., the -x direction or the +x direction).

The first-3 light control pattern 621c and the first-4 light control pattern 621d may be located at different positions in the first direction (e.g., the -x direction or the +x direction) with respect to the center MP of the corresponding green sub-pixel Pg. The center P3 of the first-3 light control pattern 621c and the center P4 of the first-4 light control pattern 621d may be located at different positions in the first direction (e.g., the -x direction or the +x direction). The first-4 light control pattern 621d and the first-1 light control pattern 621a may be located at different positions in the first direction (e.g., the -x direction or the +x direction) with respect to the center MP of the corresponding green sub-pixel Pg. The center P4 of the first-4 light control pattern 621d and the center P1 of the first-1 light control pattern 621a may be located at different positions.

For example, the center P1 of the first-1 light control pattern 621a may be located at the same position as the center MP of the first green sub-pixel Pg1, the center P2 of the first-2 light control pattern 621b may be arranged in the -x direction with respect to the center MP of the second green sub-pixel Pg2, the center P3 of the first-3 light control pattern 621c may be arranged in the +x direction with respect to the center MP of the third green sub-pixel Pg3, and the center P4 of the first-4 light control pattern 621d may be arranged in the -x direction with respect to the center MP of the fourth green sub-pixel Pg4.

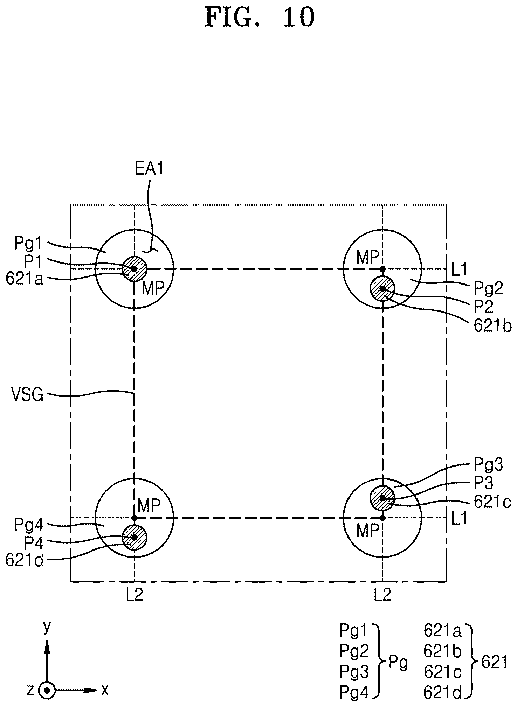

FIGS. 10, 11, and 12 are plan views illustrating some sub-pixels and light control patterns corresponding thereto in a display apparatus according to some embodiments. FIGS. 10 to 12 illustrate modifications of FIG. 7, which have differences in the layout structure of light control patterns.

Referring to FIG. 10, according to some embodiments, in a plan view, the first-1 light control pattern 621a and the first-2 light control pattern 621b may be located at the same position in the first direction (e.g., the -x direction or the +x direction) with respect to the center MP of the corresponding green sub-pixel Pg and/or at different positions in the second direction (e.g., the -y direction or the +y direction) with respect to the center MP of the corresponding green sub-pixel Pg. The center P1 of the first-1 light control pattern 621a and the center P2 of the first-2 light control pattern 621b may be located at different positions in the second direction (e.g., the -y direction or the +y direction). The first-2 light control pattern 621b and the first-3 light control pattern 621c may be located at different positions in the second direction (e.g., the -y direction or the +y direction) with respect to the center MP of the corresponding green sub-pixel Pg. The center P2 of the first-2 light control pattern 621b and the center P3 of the first-3 light control pattern 621c may be located at different positions in the second direction (e.g., the -y direction or the +y direction).

The first-3 light control pattern 621c and the first-4 light control pattern 621d may be located at different positions in the second direction (e.g., the -y direction or the +y direction) with respect to the center MP of the corresponding green sub-pixel Pg. The center P3 of the first-3 light control pattern 621c and the center P4 of the first-4 light control pattern 621d may be located at different positions in the second direction (e.g., the -y direction or the +y direction). The first-4 light control pattern 621d and the first-1 light control pattern 621a may be located at different positions in the second direction (e.g., the -y direction or the +y direction) with respect to the center MP of the corresponding green sub-pixel Pg. The center P4 of the first-4 light control pattern 621d and the center P1 of the first-1 light control pattern 621a may be located at different positions in the second direction (e.g., the -y direction or the +y direction).

For example, the center P1 of the first-1 light control pattern 621a may be located at the same position as the center MP of the first green sub-pixel Pg1, the center P2 of the first-2 light control pattern 621b may be arranged in the -y direction with respect to the center MP of the second green sub-pixel Pg2, the center P3 of the first-3 light control pattern 621c may be arranged in the +y direction with respect to the center MP of the third green sub-pixel Pg3, and the center P4 of the first-4 light control pattern 621d may be arranged in the -y direction with respect to the center MP of the fourth green sub-pixel Pg4.

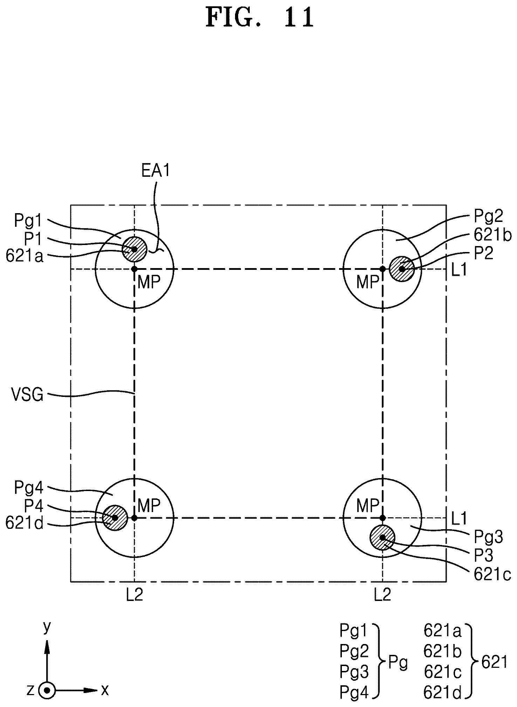

Referring to FIG. 11, according to some embodiments, in a plan view, the first-1 light control pattern 621a and the first-2 light control pattern 621b may be located at different positions in the first direction (e.g., the -x direction or the +x direction) and the second direction (e.g., the -y direction or the +y direction) with respect to the center MP of the corresponding green sub-pixel Pg. The center P1 of the first-1 light control pattern 621a and the center P2 of the first-2 light control pattern 621b may be located at different positions in the first direction (e.g., the -x direction or the +x direction) and the second direction (e.g., the -y direction or the +y direction). The first-2 light control pattern 621b and the first-3 light control pattern 621c may be located at different positions in the first direction (e.g., the -x direction or the +x direction) and the second direction (e.g., the -y direction or the +y direction) with respect to the center MP of the corresponding green sub-pixel Pg. The center P2 of the first-2 light control pattern 621b and the center P3 of the first-3 light control pattern 621c may be located at different positions in the first direction (e.g., the -x direction or the +x direction) and the second direction (e.g., the -y direction or the +y direction).

The first-3 light control pattern 621c and the first-4 light control pattern 621d may be located at different positions in the first direction (e.g., the -x direction or the +x direction) and the second direction (e.g., the -y direction or the +y direction) with respect to the center MP of the corresponding green sub-pixel Pg. The center P3 of the first-3 light control pattern 621c and the center P4 of the first-4 light control pattern 621d may be located at different positions in the first direction (e.g., the -x direction or the +x direction) and the second direction (e.g., the -y direction or the +y direction). The first-4 light control pattern 621d and the first-1 light control pattern 621a may be located at different positions in the first direction (e.g., the -x direction or the +x direction) and the second direction (e.g., the -y direction or the +y direction) with respect to the center MP of the corresponding green sub-pixel Pg. The center P4 of the first-4 light control pattern 621d and the center P1 of the first-1 light control pattern 621a may be located at different positions in the first direction (e.g., the -x direction or the +x direction) and the second direction (e.g., the -y direction or the +y direction).

For example, the center P1 of the first-1 light control pattern 621a may be arranged in the +y direction with respect to the center MP of the first green sub-pixel Pg1, the center P2 of the first-2 light control pattern 621b may be arranged in the +x direction with respect to the center MP of the second green sub-pixel Pg2, the center P3 of the first-3 light control pattern 621c may be arranged in the -y direction with respect to the center MP of the third green sub-pixel Pg3, and the center P4 of the first-4 light control pattern 621d may be arranged in the -x direction with respect to the center MP of the fourth green sub-pixel Pg4.

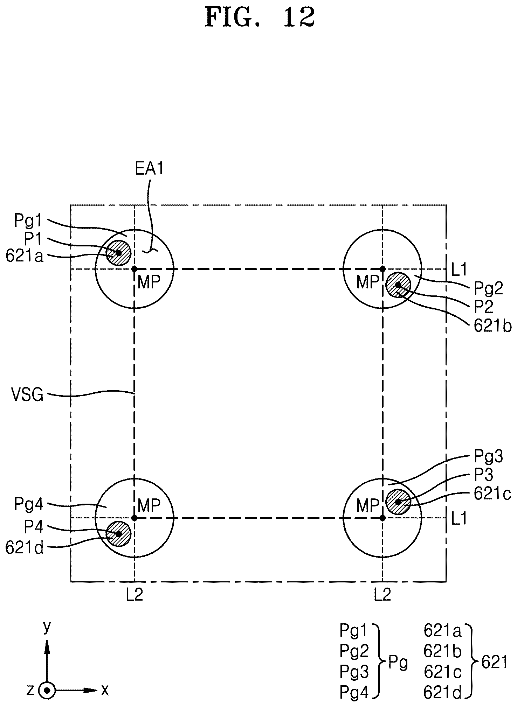

Referring to FIG. 12, according to some embodiments, in a plan view, the first-1 light control pattern 621a and the first-2 light control pattern 621b may be located at different positions in the first direction (e.g., the -x direction or the +x direction) and/or the second direction (e.g., the -y direction or the +y direction) with respect to the center MP of the corresponding green sub-pixel Pg. The center P1 of the first-1 light control pattern 621a and the center P2 of the first-2 light control pattern 621b may be located at positions shifted in the first direction (e.g., the -x direction or the +x direction) and the second direction (e.g., the -y direction or the +y direction) with respect to the center MP of the green sub-pixel Pg. The center P1 of the first-1 light control pattern 621a and the center P2 of the first-2 light control pattern 621b may be located at different positions in the first direction (e.g., the -x direction or the +x direction) and/or the second direction (e.g., the -y direction or the +y direction).

The first-2 light control pattern 621b and the first-3 light control pattern 621c may be located at different positions in the first direction (e.g., the -x direction or the +x direction) and/or the second direction (e.g., the -y direction or the +y direction) with respect to the center MP of the corresponding green sub-pixel Pg. The center P2 of the first-2 light control pattern 621b and the center P3 of the first-3 light control pattern 621c may be located at positions shifted in the first direction (e.g., the -x direction or the +x direction) and the second direction (e.g., the -y direction or the +y direction) with respect to the center MP of the green sub-pixel Pg. The center P2 of the first-2 light control pattern 621b and the center P3 of the first-3 light control pattern 621c may be located at different positions in the first direction (e.g., the -x direction or the +x direction) and/or the second direction (e.g., the -y direction or the +y direction).

The first-3 light control pattern 621c and the first-4 light control pattern 621d may be located at different positions in the first direction (e.g., the -x direction or the +x direction) and/or the second direction (e.g., the -y direction or the +y direction) with respect to the center MP of the corresponding green sub-pixel Pg. The center P3 of the first-3 light control pattern 621c and the center P4 of the first-4 light control pattern 621d may be located at positions shifted in the first direction (e.g., the -x direction or the +x direction) and the second direction (e.g., the -y direction or the +y direction) with respect to the center MP of the green sub-pixel Pg. The center P3 of the first-3 light control pattern 621c and the center P4 of the first-4 light control pattern 621d may be located at different positions in the first direction (e.g., the -x direction or the +x direction) and/or the second direction (e.g., the -y direction or the +y direction).

The first-4 light control pattern 621d and the first-1 light control pattern 621a may be located at different positions in the first direction (e.g., the -x direction or the +x direction) and/or the second direction (e.g., the -y direction or the +y direction) with respect to the center MP of the corresponding green sub-pixel Pg. The center P4 of the first-4 light control pattern 621d and the center P1 of the first-1 light control pattern 621a may be located at positions shifted in the first direction (e.g., the -x direction or the +x direction) and the second direction (e.g., the -y direction or the +y direction) with respect to the center MP of the green sub-pixel Pg. The center P4 of the first-4 light control pattern 621d and the center P1 of the first-1 light control pattern 621a may be located at different positions in the first direction (e.g., the -x direction or the +x direction) and/or the second direction (e.g., the -y direction or the +y direction).

For example, the center P1 of the first-1 light control pattern 621a may be arranged in the -x direction and the +y direction with respect to the center MP of the first green sub-pixel Pg1, the center P2 of the first-2 light control pattern 621b may be arranged in the +x direction and the -y direction with respect to the center MP of the second green sub-pixel Pg2, the center P3 of the first-3 light control pattern 621c may be arranged in the +x direction and the +y direction with respect to the center MP of the third green sub-pixel Pg3, and the center P4 of the first-4 light control pattern 621d may be arranged in the -x direction and the -y direction with respect to the center MP of the fourth green sub-pixel Pg4.

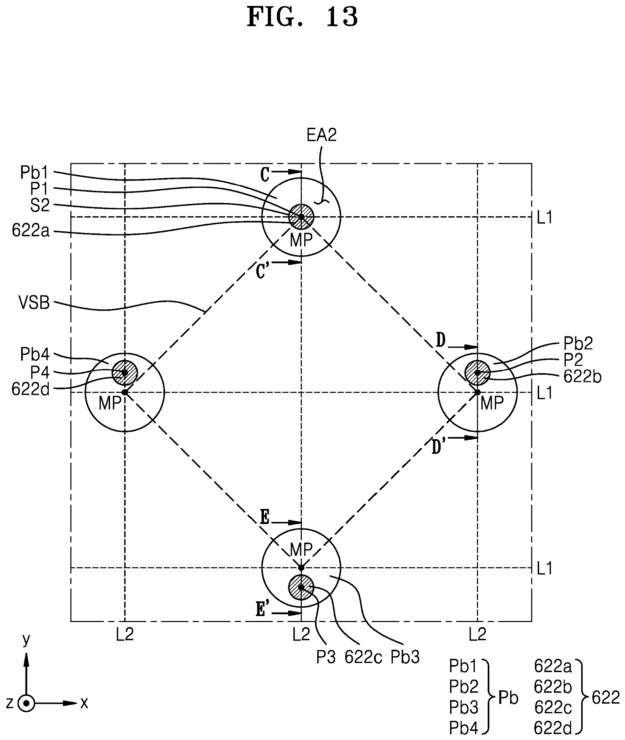

For convenience of explanation, the layout structure of the first light control patterns 621 in adjacent green sub-pixels Pg is mainly described with reference to FIGS. 7 to 12. The description of the first light control patterns 621 corresponding to the green sub-pixels Pg may be equally applied to the second light control patterns 622 corresponding to the blue sub-pixels Pb and the third light control patterns 623 corresponding to the red sub-pixels Pr. Hereinafter, the layout structures of the second light control patterns 622 and the third light control patterns 623 are described with reference to FIGS. 13 to 16.

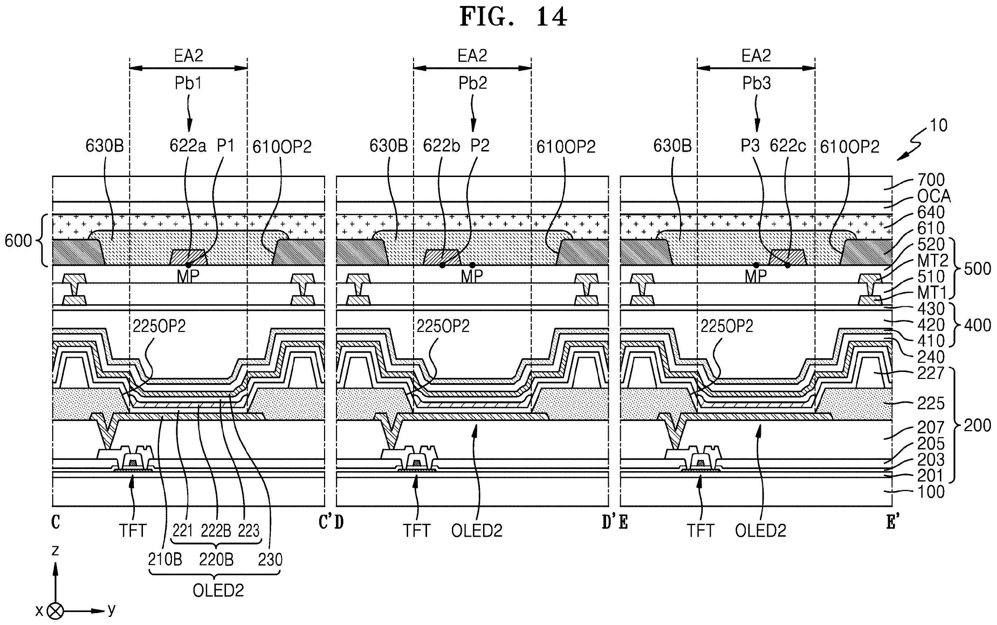

FIG. 13 is a plan view illustrating some sub-pixels and light control patterns corresponding thereto in a display apparatus according to some embodiments. FIG. 13 illustrates an example of light control patterns that may be arranged to correspond to the respective blue sub-pixels by extracting some blue sub-pixels among the sub-pixels illustrated in FIG. 6. FIG. 14 is a cross-sectional view schematically illustrating a portion of the display apparatus taken along the lines C-C', D-D' and E-E' of FIG. 13, according to some embodiments.

Referring to FIGS. 13 and 14, the blue sub-pixels Pb of the display apparatus 10 may include a first blue sub-pixel Pb1, a second blue sub-pixel Pb2, a third blue sub-pixel Pb3, and a fourth blue sub-pixel Pb4, which are located at vertices of a virtual quadrangle VSB. The first blue sub-pixel Pb1 and the second blue sub-pixel Pb2 may be located adjacent to each other, the second blue sub-pixel Pb2 and the third blue sub-pixel Pb3 may be located adjacent to each other, the third blue sub-pixel Pb3 and the fourth blue sub-pixel Pb4, and the fourth blue sub-pixel Pb4 and the first blue sub-pixel Pb1 may be located adjacent to each other.

Second light control patterns 622 may include second-1 to second-4 light control patterns 622a, 622b, 622c, and 622d respectively corresponding to the first to fourth blue sub-pixels Pb1, Pb2, Pb3, and Pb4. The second-1 light control pattern 622a may be located in an emission area EA2 of the first blue sub-pixel Pb1. The second-2 light control pattern 622b may be located in an emission area EA2 of the second blue sub-pixel Pb2. The second-3 light control pattern 622c may be located in an emission area EA2 of the third blue sub-pixel Pb3. The second-4 light control pattern 622d may be located in an emission area EA2 of the fourth blue sub-pixel Pb4.

In a plan view, each of the second light control patterns 622 may have an area S2 corresponding to 10 % to 80 % of the area of the emission area EA2 of the corresponding blue sub-pixel Pb. For example, each of the second light control patterns 622 may have an area S2 corresponding to 20 % to 75 % of the area of the emission area EA2 of the corresponding blue sub-pixel Pb. For example, each of the second light control patterns 622 may have an area S2 corresponding to 25 % to 50 % of the area of the emission area EA2 of the corresponding blue sub-pixel Pb. When the area S2 of each of the second light control patterns 622 is less than 10 % with respect to the area of the emission area EA2 of the blue sub-pixel Pb, the effect of relatively improving the interference pattern by the light control patterns may be minimal. On the other hand, when the area S2 of each of the second light control patterns 622 is greater than 80 % with respect to the area of the emission area EA2 of the blue sub-pixel Pb, the light emission efficiency of the display apparatus may decrease.

According to some embodiments, the second light control patterns 622 may have the same size (or area). For example, the second-1 to second-4 light control patterns 622a to 622d may have the same size (or area).

In a plan view, the second light control patterns 622 located on two adjacent blue sub-pixels Pb may be located at different positions in at least one of the first direction (e.g., the -x direction or the +x direction) or the second direction (e.g., the -y direction or the +y direction) with respect to the center of the corresponding blue sub-pixel Pb.

Referring to FIGS. 13 and 14, for example, in a plan view, the second-1 light control pattern 622a and the second-2 light control pattern 622b may be located at different positions in the second direction (e.g., the -y direction or the +y direction) with respect to the center MP of the corresponding blue sub-pixel Pb. The center P1 of the second-1 light control pattern 622a and the center P2 of the second-2 light control pattern 622b may be located at different positions in the second direction (e.g., the -y direction or the +y direction). The second-2 light control pattern 622b and the second-3 light control pattern 622c may be located at different positions in the second direction (e.g., the -y direction or the +y direction) with respect to the center MP of the corresponding blue sub-pixel Pb. The center P2 of the second-2 light control pattern 622b and the center P3 of the second-3 light control pattern 622c may be located at different positions in the second direction (e.g., the -y direction or the +y direction).

The second-3 light control pattern 622c and the second-4 light control pattern 622d may be located at different positions in the second direction (e.g., the -y direction or the +y direction) with respect to the center MP of the corresponding blue sub-pixel Pb. The center P3 of the second-3 light control pattern 622c and the center P4 of the second-4 light control pattern 622d may be located at different positions in the second direction (e.g., the -y direction or the +y direction). The second-4 light control pattern 622d and the second-1 light control pattern 622a may be located at different positions in the second direction (e.g., the -y direction or the +y direction) with respect to the center MP of the corresponding blue sub-pixel Pb. The center P4 of the second-4 light control pattern 622d and the center P1 of the second-1 light control pattern 622a may be located at different positions in the second direction (e.g., the -y direction or the +y direction).

For example, the center P1 of the second-1 light control pattern 622a may be located at the same position as the center MP of the blue sub-pixel Pb, the center P2 of the second-2 light control pattern 622b and the center P4 of the second-4 light control pattern 622d may be arranged in the +y direction with respect to the center MP of the blue sub-pixel Pb, and the center P3 of the second-3 light control pattern 622c may be arranged in the -y direction with respect to the center MP of the blue sub-pixel Pb.

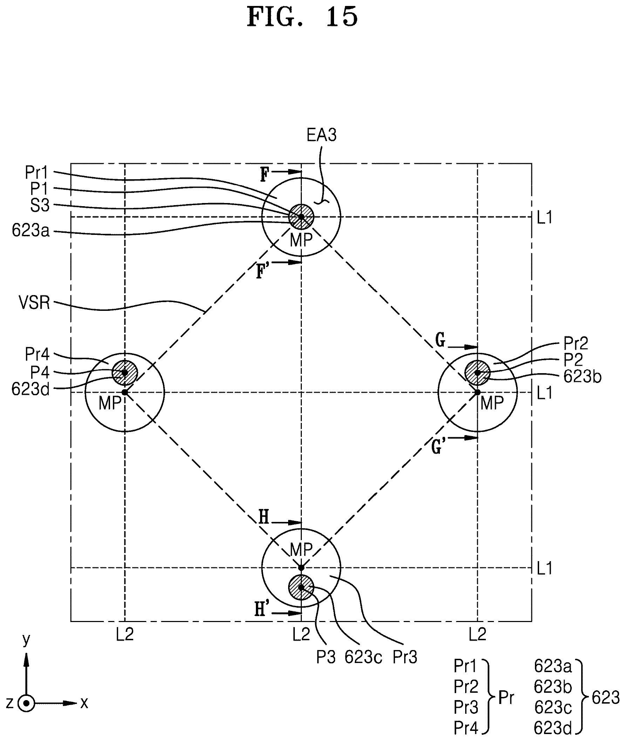

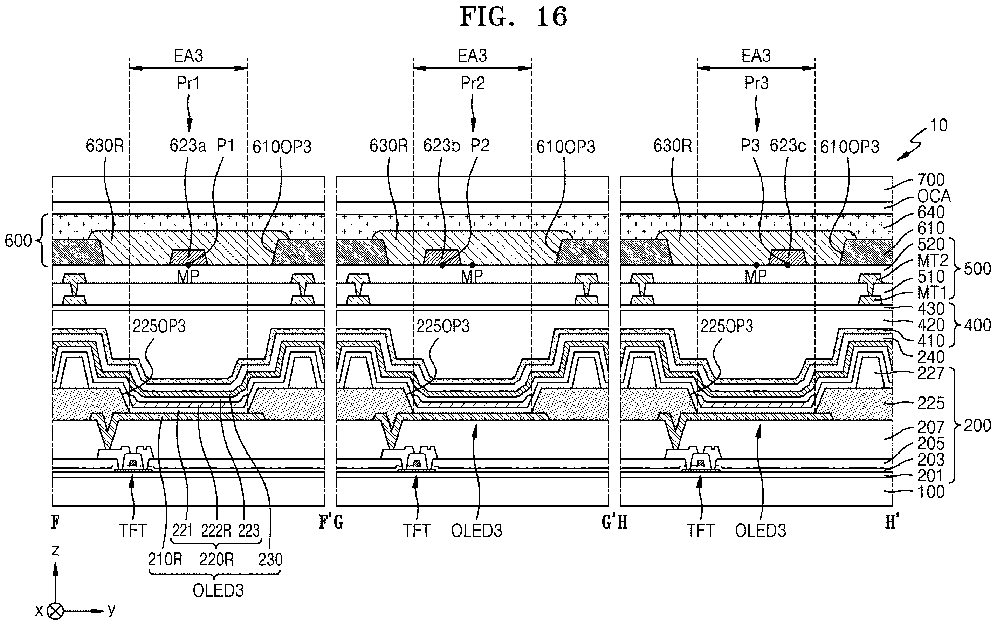

FIG. 15 is a plan view illustrating some sub-pixels and light control patterns corresponding thereto in a display apparatus according to some embodiments. FIG. 15 illustrates an example of light control patterns that may be arranged to correspond to the respective red sub-pixels by extracting some red sub-pixels among the sub-pixels illustrated in FIG. 6. FIG. 16 is a cross-sectional view schematically illustrating a portion of the display apparatus taken along the lines F-F', G-G', and H-H' of FIG. 15, according to some embodiments.

Referring to FIGS. 15 and 16, the red sub-pixels Pr of the display apparatus 10 may include a first red sub-pixel Pr1, a second red sub-pixel Pr2, a third red sub-pixel Pr3, and a fourth red sub-pixel Pr4, which are located at vertices of a virtual quadrangle VSR. The first red sub-pixel Pr1 and the second red sub-pixel Pr2 may be located adjacent to each other, the second red sub-pixel Pr2 and the third red sub-pixel Pr3 may be located adjacent to each other, the third red sub-pixel Pr3 and the fourth red sub-pixel Pr4 may be located adjacent to each other, and the fourth red sub-pixel Pr4 and the first red sub-pixel Pr4 may be located adjacent to each other.

Third light control patterns 623 may include third-1 to third-4 light control patterns 623a, 623b, 623c, and 623d respectively corresponding to the first to fourth red sub-pixels Pr1, Pr2, Pr3, and Pr4. The third-1 light control pattern 623a may be located in an emission area EA3 of the first red sub-pixel Pr1. The third-2 light control pattern 623b may be located in an emission area EA3 of the second red sub-pixel Pr2. The third-3 light control pattern 623c may be located in an emission area EA3 of the third red sub-pixel Pr3. The third-4 light control pattern 623d may be located in an emission area EA3 of the fourth red sub-pixel Pr4.

In a plan view, each of the third light control patterns 623 may have an area S3 corresponding to 10 % to 80 % of the area of the emission area EA3 of the corresponding red sub-pixel Pr. For example, each of the third light control patterns 623 may have an area S3 corresponding to 20 % to 75 % of the area of the emission area EA3 of the corresponding red sub-pixel Pr. For example, each of the third light control patterns 623 may have an area S3 corresponding to 25 % to 50 % of the area of the emission area EA3 of the corresponding red sub-pixel Pr. When the area S3 of each of the third light control patterns 623 is less than 10 % with respect to the area of the emission area EA3 of the red sub-pixel Pr, the effect of relatively improving the interference pattern by the light control patterns may be minimal. On the other hand, when the area S3 of each of the third light control patterns 623 is greater than 80 % with respect to the area of the emission area EA3 of the red sub-pixel Pr, the light emission efficiency of the display apparatus may decrease.

According to some embodiments, the third light control patterns 623 may have the same size (or area). For example, the third-1 to third-4 light control patterns 623a to 623d may have the same size (or area).

In a plan view, the third light control patterns 623 located on two adjacent red sub-pixels Pr may be located at different positions in at least one of the first direction (e.g., the -x direction or the +x direction) or the second direction (e.g., the -y direction or the +y direction) with respect to the center of the corresponding red sub-pixel Pr.

Referring to FIGS. 15 and 16, for example, in a plan view, the third-1 light control pattern 623a and the third-2 light control pattern 623b may be located at different positions in the second direction (e.g., the -y direction or the +y direction) with respect to the center MP of the corresponding red sub-pixel Pr. The center P1 of the third-1 light control pattern 623a and the center P2 of the third-2 light control pattern 623b may be located at different positions in the second direction (e.g., the -y direction or the +y direction). The third-2 light control pattern 623b and the third-3 light control pattern 623c may be located at different positions in the second direction (e.g., the -y direction or the +y direction) with respect to the center MP of the corresponding red sub-pixel Pr. The center P2 of the third-2 light control pattern 623b and the center P3 of the third-3 light control pattern 623c may be located at different positions in the second direction (e.g., the -y direction or the +y direction).

The third-3 light control pattern 623c and the third-4 light control pattern 623d may be located at different positions in the second direction (e.g., the -y direction or the +y direction) with respect to the center MP of the corresponding red sub-pixel Pr. The center P3 of the third-3 light control pattern 623c and the center P4 of the third-4 light control pattern 623d may be located at different positions in the second direction (e.g., the -y direction or the +y direction). The third-4 light control pattern 623d and the third-1 light control pattern 623a may be located at different positions in the second direction (e.g., the -y direction or the +y direction) with respect to the center MP of the corresponding red sub-pixel Pr. The center P4 of the third-4 light control pattern 623d and the center P1 of the third-1 light control pattern 623a may be located at different positions in the second direction (e.g., the -y direction or the +y direction).

For example, the center P1 of the third-1 light control pattern 623a may be located at the same position as the center MP of the red sub-pixel Pr, the center P2 of the third-2 light control pattern 623b and the center P4 of the third-4 light control pattern 623d may be arranged in the +y direction with respect to the center MP of the red sub-pixel Pr, and the center P3 of the third-3 light control pattern 623c may be arranged in the -y direction with respect to the center MP of the red sub-pixel Pr.

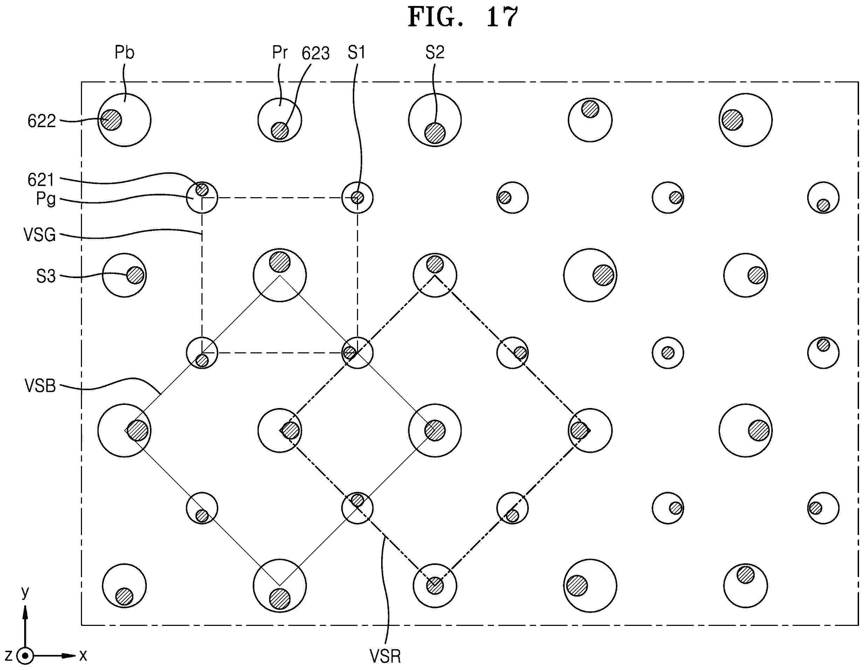

FIG. 17 is a plan view illustrating some sub-pixels and light control patterns corresponding thereto in a portion of a display apparatus according to some embodiments. FIG. 17 illustrates an example of the layout structure of the first light control patterns 621, the second light control patterns 622, and the third light control patterns 623 in the sub-pixel layout structure of FIG. 6.

As described above, the first light control patterns 621 (each) may have the same size (or area). The second light control patterns 622 may have the same size (or area). The third light control patterns 623 may have the same size (or area).

According to some embodiments, the first light control pattern 621, the second light control pattern 622, and the third light control pattern 623 may have different areas. For example, the area S1 of the first light control pattern 621 may be less than the area S2 of the second light control pattern 622 and the area S3 of the third light control pattern 623. The area S2 of the second light control pattern 622 may be greater than the area S3 of the third light control pattern 623. However, the disclosure is not necessarily limited thereto. According to some embodiments, at least two of the first light control pattern 621, the second light control pattern 622, and the third light control pattern 623 may have substantially the same area.

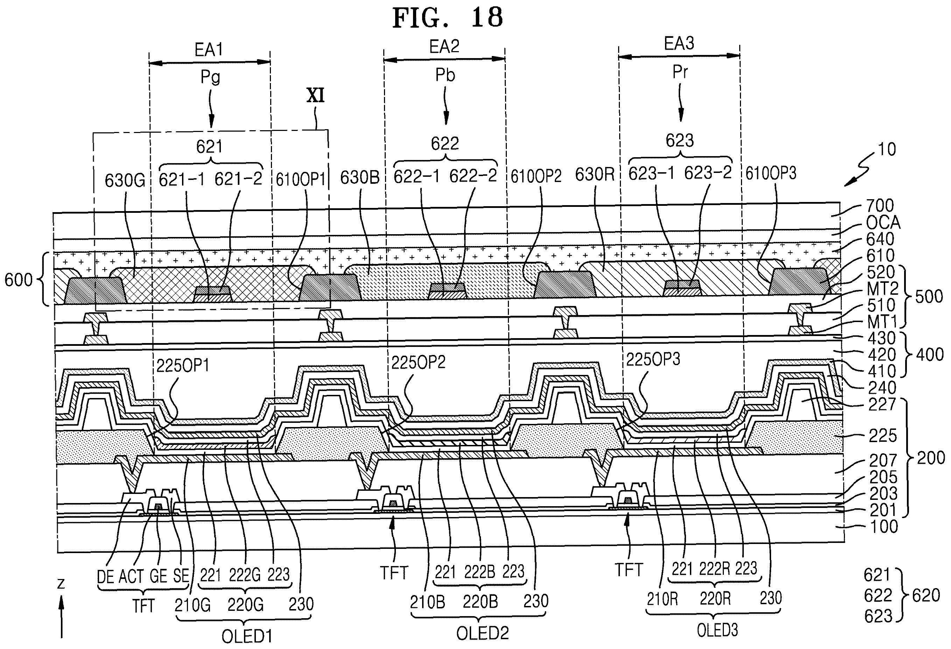

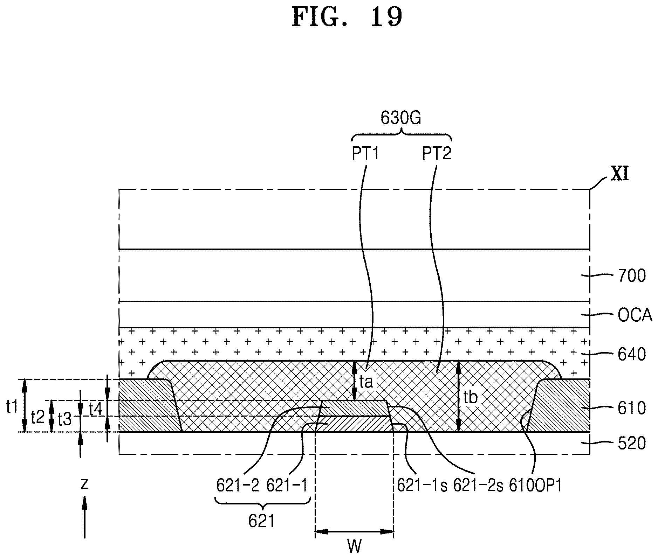

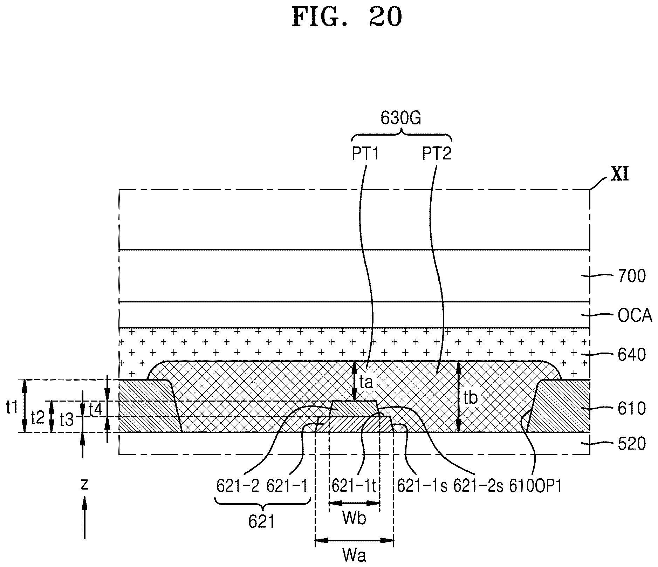

FIG. 18 is a schematic cross-sectional view of a display apparatus according to some embodiments. FIGS. 19 and 20 are schematic enlarged cross-sectional view of region XI of the display apparatus of FIG. 18 according to some embodiments. FIGS. 18 to 20 illustrate modifications of FIGS. 4 and 5. Hereinafter, redundant descriptions are omitted and differences are mainly described.

Referring to FIG. 18, a light control layer 620 may include light control patterns spaced apart from each other to correspond to each sub-pixel. The light control patterns may include a first light control pattern 621 corresponding to a first color sub-pixel (e.g., a green sub-pixel Pg), a second light control pattern 622 corresponding to a second color sub-pixel (e.g., a blue sub-pixel Pb), and a third light control pattern 623 corresponding to a third color sub-pixel (e.g., a red sub-pixel Pr).

According to some embodiments, each of the light control patterns of the light control layer 620 may include a first-layer light control pattern and a second-layer light control pattern. The second-layer light control pattern may overlap the first-layer light control pattern and may be located on the first-layer light control pattern. For example, the first light control pattern 621 may include a first-layer first light control pattern 621-1 and a second-layer first light control pattern 621-2. The second light control pattern 622 may include a first-layer second light control pattern 622-1 and a second-layer second light control pattern 622-2. The third light control pattern 623 may include a first-layer third light control pattern 623-1 and a second-layer third light control pattern 623-2.

According to some embodiments, each of the light control patterns of the light control layer 620 may include a scattering pattern and a light-blocking pattern. The first-layer light control patterns 621-1, 622-1, and 623-1 of the first to third light control patterns 621, 622, and 623 may be scattering patterns, and the second-layer light control patterns 621-2, 622-2, and 623-2 may be light-blocking patterns.

The first-layer light control patterns 621-1, 622-1, and 623-1 of the light control layer 620 may include scattering particles for scattering at least a portion of light incident on the light control layer 620. The scattering particles may include metal oxide, such as TiO₂. The size of the scattering particles may be 200 nm or more. The scattering particles may have a surface roughness of 50 nm or more so as to facilitate reflection and/or scattering of light from the surface. According to some embodiments, the first-layer light control patterns 621-1, 622-1, and 623-1 of the light control layer 620 may include an organic insulating material in which scattering particles are dispersed, such as polyimides resin, acryl resin, or BCB. The first-layer light control patterns 621-1, 622-1, and 623-1 may relatively improve the side viewing angle by scattering incident light.

The second-layer light control patterns 621-2, 622-2, and 623-2 of the light control layer 620 may include the same material as the material of the second bank layer 610. The second-layer light control patterns 621-2, 622-2, and 623-2 may be formed by using a half-tone mask in the same process as the second bank layer 610. Each of the second-layer light control patterns 621-2, 622-2, and 623-2 may include a light-blocking material. For example, the light-blocking material of each of the second-layer light control patterns 621-2, 622-2, and 623-2 may be black. The light-blocking material may include carbon black, carbon nanotubes, a resin or paste including black dye, metal particles (e.g., nickel, aluminum, molybdenum, and any alloy thereof), metal oxide particles, or metal nitride particles. The second-layer light control patterns 621-2, 622-2, and 623-2 may absorb external light and reduce external light reflectance.

First to third color filters 630G, 630B, and 630R may respectively cover the first to third light control patterns 621, 622, and 623.

Referring to FIGS. 18, 19, and 20, a thickness t1 of the second bank layer 610 may be greater than a thickness t2 of the first light control pattern 621 of the light control layer 620. The thickness t1 of the second bank layer 610 may be greater than a thickness t3 of the first-layer first light control pattern 621-1 of the first light control pattern 621 and a thickness t4 of the second-layer first light control pattern 621-2 of the first light control pattern 621.

According to some embodiments, the thickness t3 of the first-layer first light control pattern 621-1 of the first light control pattern 621 of the light control layer 620 may be substantially equal to the thickness t4 of the second-layer first light control pattern 621-2. However, the disclosure is not limited thereto. According to some embodiments, a ratio of the thickness t3 of the first-layer first light control pattern 621-1 of the first light control pattern 621 of the light control layer 620 to the thickness t4 of the second-layer first light control pattern 621-2 may be variously designed.

The first color filter 630G may be located on a portion of the top surface of the second bank layer 610. The first color filter 630G may include a first portion PT1 located on the first light control pattern 621 and a second portion PT2 that does not overlap the first light control pattern 621. The second portion PT2 may be a portion that comes into contact with the touch sensor layer 500, for example, the second touch insulating layer 520. According to some embodiments, a thickness ta of the first portion PT1 of the first color filter 630G may be less than a thickness tb of the second portion PT2.

The width (or size) of each of the second-layer light control patterns 621-2, 622-2, and 623-2 of the first to third light control patterns 621, 622, and 623 of the light control layer 620 may be less than or equal to the width (or size) of each of the first-layer light control patterns 621-1, 622-1, and 623-1.

According to some embodiments, as illustrated in FIG. 19, the width W of the second-layer first light control pattern 621-2 of the first light control pattern 621 may be equal to the width W of the first-layer first light control pattern 621-1. However, the disclosure is not limited thereto. Referring to FIG. 20, according to some embodiments, the width Wb of the second-layer first light control pattern 621-2 of the first light control pattern 621 may be less than the width Wa of the first-layer first light control pattern 621-1.

According to some embodiments, as illustrated in FIG. 19, in a cross-sectional view, the side surface 621-2s of the second-layer first light control pattern 621-2 of the first light control pattern 621 and the side surface 621-1s of the first-layer first light control pattern 621-1 may be located on the same line. However, the disclosure is not limited thereto. According to some embodiments, as illustrated in FIG. 20, in a cross-sectional view, the side surface 621-2s of the second-layer first light control pattern 621-2 of the first light control pattern 621 and the side surface 621-1s of the first-layer first light control pattern 621-1 may not be located on the same line. In this case, the top surface of the first light control pattern 621 may have a step. A portion of the top surface 621-1t of the first-layer first light control pattern 621-1 of the first light control pattern 621 may be exposed. The first color filter 630G may be in direct contact with a portion of the top surface 621-1t of the exposed first-layer first light control pattern 621-1.

In FIGS. 19 and 20, the first light control pattern 621 and the first color filter 630G of the light control layer 620 are described as an example, but the same description may be applied to the second light control pattern 622 and the second color filter 630B, and the third light control pattern 623 and the third color filter 630R.

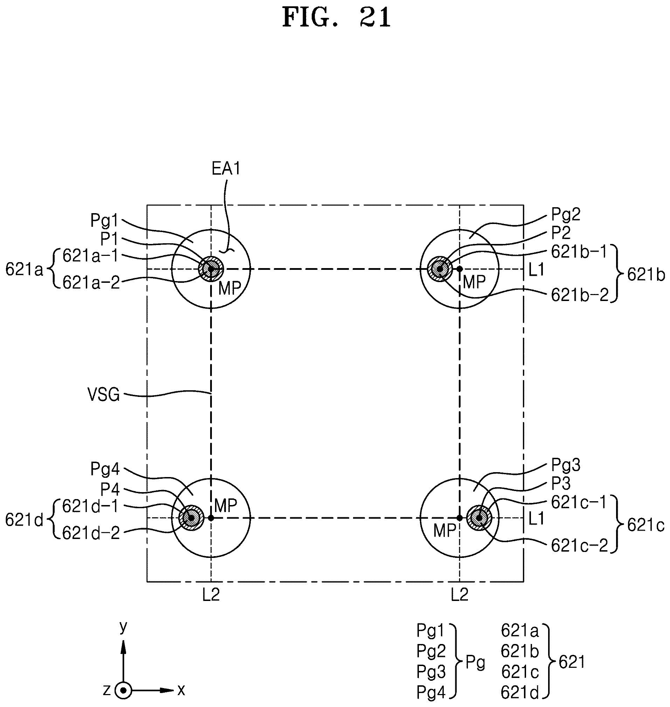

FIG. 21 is a plan view illustrating some sub-pixels and light control patterns corresponding thereto in a display apparatus according to some embodiments. For convenience of explanation, FIG. 21 illustrates an example of the layout structure of the first light control patterns 621 having the first-layer first light control pattern 621-1 and the second-layer first light control pattern 621-2 in the adjacent green sub-pixels Pg. Furthermore, FIG. 21 illustrates a case where the width (or size) of the second-layer first light control pattern 621-2 of each of the first light control patterns 621 is less than the width (or size) of the first-layer first light control pattern 621-1. The description of the first light control patterns 621 corresponding to the green sub-pixels Pg may be equally applied to the second light control patterns 622 corresponding to the blue sub-pixels Pb and the third light control patterns 623 corresponding to the red sub-pixels Pr.

Referring to FIG. 21, in a plan view, the first-layer first light control pattern 621-1 of each of the first light control patterns 621 may have the same shape as the shape of the second-layer first light control pattern 621-2. In FIG. 21, as an example, the first-layer first light control pattern 621-1 of each of the first light control patterns 621 may have the same circular shape as the circular shape of the second-layer first light control pattern 621-2.

In a plan view, the first light control patterns 621 located on two adjacent green sub-pixels Pg may be located at different positions in at least one of the first direction (e.g., the -x direction or the +x direction) or the second direction (e.g., the -y direction or the +y direction) perpendicular to the first direction (e.g., the -x direction or the +x direction) with respect to the center of the corresponding green sub-pixel Pg. In the first light control pattern 621, the center of the first-layer light control pattern may be the same as the center of the second-layer light control pattern. In a first-1 light control pattern 621a, a center P1 of a first-layer first-1 light control pattern 621a-1 may be the same as a center P1 of a second-layer first-1 light control pattern 621a-2. In a first-2 light control pattern 621b, a center P2 of a first-layer first-2 light control pattern 621b-1 may be the same as a center P2 of a second-layer first-2 light control pattern 621b-2. In a first-3 light control pattern 621c, a center P3 of a first-layer first-3 light control pattern 621c-1 may be the same as a center P3 of a second-layer first-3 light control pattern 621c-2. In a first-4 light control pattern 621d, a center P4 of a first-layer first-4 light control pattern 621d-1 may be the same as a center P4 of a second-layer first-4 light control pattern 621d-2.

As an example, as illustrated in FIG. 21, the centers P1 of the first-layer first-1 light control pattern 621a-1 and the second-layer first-2 light control pattern 621a-2 of the first-1 light control pattern 621a may be located at the same position as a center MP of a first green sub-pixel Pg1, the centers P2 of the first-layer first-2 light control pattern 621b-1 and the second-layer first-2 light control pattern 621b-2 of the first-2 light control pattern 621b may be arranged in the -x direction with respect to a center MP of a second green sub-pixel Pg2, and the centers P3 of the first-layer first-3 light control pattern 621c-1 and the second-layer first-3 light control pattern 621c-2 of the first-3 light control pattern 621c-2 may be arranged in the +x direction with respect to the a center MP of a third green sub-pixel Pg1, and the centers P4 of the first-layer first-4 light control pattern 621d-1 and the second-layer first-4 light control pattern 621d-2 of the first-4 light control pattern 621d may be arranged in the -x direction with respect to a center MP of a green sub-pixel Pg.

As described as an example with reference to FIG. 21, the first-layer light control patterns and the second-layer light control patterns of the light control patterns may have a layout structure that is identical to or similar to a layout structure of the light control patterns described above with reference to FIGS. 7 to 16. A detailed description of the layout structure of each of the first-layer light control patterns and the second-layer light control patterns that constitute the light control patterns is omitted.

In the display apparatus 10 according to some embodiments, light control patterns corresponding to two adjacent sub-pixels among the sub-pixels of the same color may be located at different positions with respect to the center of each sub-pixel. Each of the light control patterns may include a first-layer light control pattern and a second-layer light control pattern. The first-layer light control pattern may include a scattering pattern and the second-layer light control pattern may include a light-blocking pattern. Accordingly, an interference pattern formed by light reflected and/or scattered from the adjacent sub-pixels of the same color may be reduced, the side viewing angle may be relatively improved, and external light reflectance may be reduced by absorbing external light.

The display apparatus according to the embodiments described above may be applied to various electronic devices. An electronic device according to some embodiments may include the display apparatus described above and may further include, in addition to the display apparatus, modules or devices having other additional functions.

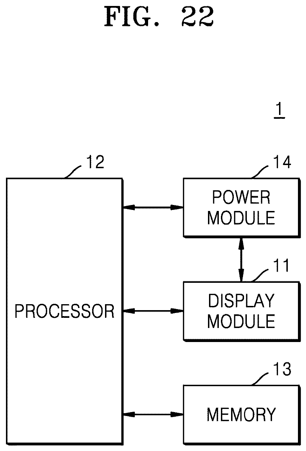

FIG. 22 is a block diagram of the electronic device 1 according to some embodiments.

Referring to FIG. 22, the electronic device 1 according to some embodiments may include a display module 11, a processor 12, a memory 13, and a power module 14.

The processor 12 may include at least one of a central processing unit (CPU), an application processor (AP), a graphics processing unit (GPU), a communication processor (CP), an image signal processor (ISP), or a controller.

Data information necessary for the operation of the processor 12 or the display module 11 may be stored in the memory 13. When the processor 12 executes an application stored in the memory 13, an image data signal and/or an input control signal may be transmitted to the display module 11, and the display module 11 may process the received signal and output image information on a display screen.

The power module 14 may include a power supply module, such as a power adapter or a battery device, and a power conversion module configured to convert power supplied by the power supply module to generate power necessary for the operation of the electronic device 1.

At least one of the components of the electronic device 1 may be included in the display apparatus according to the embodiments described above. Furthermore, some of the individual modules functionally included in a single module may be included in the display apparatus, and others may be provided separately from the display apparatus. For example, the display apparatus may include the display module 11, and the processor 12, the memory 13, and the power module 14 may be provided in the form of other devices within the electronic device 1 other than the display apparatus.

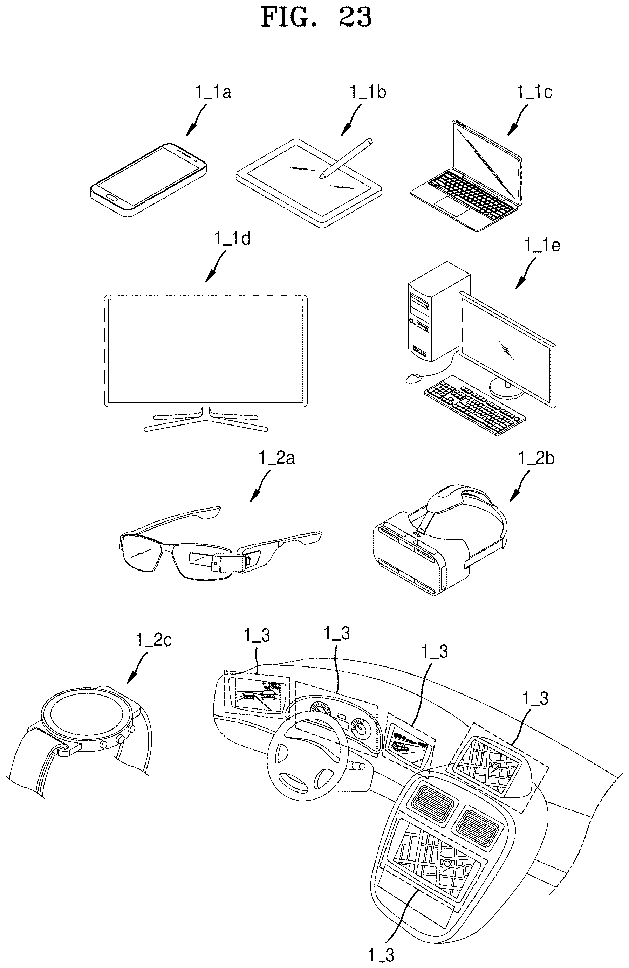

FIG. 23 is schematic diagrams of electronic devices according to various embodiments.

Referring to FIG. 23, various electronic devices, to which the display apparatuses according to embodiments are applied, may include electronic devices for mage display, such as a smartphone 1_1a, a tablet personal computer (PC) 1_1b, a laptop 1_1c, a television (TV) 1_1d, or a desk monitor 1_1e, wearable electronic devices each including a display module, such as smart glasses 1_2a, a head mounted display 1_2b, or a smart watch 1_2c, and vehicle electronic devices 1_3 each including a display module, such as dashboards of automobiles, center information displays (CIDs) on the center fascia or dashboards of automobiles, or room mirror displays.

According to some embodiments, a display apparatus having excellent display quality and relatively improved interference patterns due to external light reflection and diffraction and an electronic device including the display apparatus may be provided. The scope of the disclosure is not limited by such characteristics.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display apparatus (10) comprising:
a substrate (100);
sub-pixels comprising first color sub-pixels, second color sub-pixels and third color sub-pixels each comprising a sub-pixel electrode (210B, 210G, 210R) on the substrate (100), an emission layer (222B, 222G, 222R) on the sub-pixel electrode (210B, 210G, 210R), and an opposite electrode (230) on the emission layer (222B, 222G, 222R);
a first bank layer (225) comprising lower openings defining an emission area in each of the sub-pixels;
a second bank layer (610) on the first bank layer (225) and comprising upper openings respectively overlapping the lower openings;
a light control layer (620) comprising light control patterns (621, 622, 623) spaced apart from each other on the first bank layer (225) and respectively corresponding to the sub-pixels; and
color filters (630G, 630B, 630R) on the second bank layer (610) and comprising first color filters (630G), second color filters (630B), and third color filters (630R),
wherein the light control patterns (621, 622, 623) comprise first light control patterns (621) respectively corresponding to the first color sub-pixels, second light control patterns (622) respectively corresponding to the second color sub-pixels, and third light control patterns (623) respectively corresponding to the third color sub-pixels,
the first light control patterns (621) comprise a first-1 light control pattern (621a) and a first-2 light control pattern (621b) respectively corresponding to two first color sub-pixels adjacent to each other among the first color sub-pixels, and
in a plan view, the first-1 light control pattern (621a) and the first-2 light control pattern (621b) are at different positions in at least one of a first direction or a second direction perpendicular to the first direction with respect to a center of the first color sub-pixel corresponding thereto.

2. The display apparatus (10) of claim 1, wherein
the second light control patterns (622) comprise a second-1 light control pattern (622a) and a second-2 light control pattern (622b) respectively corresponding to two second color sub-pixels adjacent to each other among the second color sub-pixels, and
in the plan view, the second-1 light control pattern (622a) and the second-2 light control pattern (622b) are at different positions in at least one of the first direction or the second direction with respect to a center of the second color sub-pixel corresponding thereto, and/or wherein
the third light control patterns (623) comprise a third-1 light control pattern (623a) and a third-2 light control pattern (623b) respectively corresponding to two third color sub-pixels adjacent to each other among the third color sub-pixels, and
in the plan view, the third-1 light control pattern (623a) and the third-2 light control pattern (623b) are at different positions in at least one of the first direction or the second direction with respect to a center of the third color sub-pixel corresponding thereto.

3. The display apparatus (10) of claim 1, wherein, in the plan view, each of the light control patterns (621, 622, 623) is in an emission area of a corresponding sub-pixel among the sub-pixels and/or wherein each of the light control patterns (621, 622, 623) is in a corresponding upper opening among the upper openings of the second bank layer (610).

4. The display apparatus (10) of claim 1, wherein, in the plan view, each of the light control patterns (621, 622, 623) has an area corresponding to 10 % to 80 % of an area of an emission area of a corresponding sub-pixel among the sub-pixels.

5. The display apparatus (10) of claim 1, further comprising:
an encapsulation layer (400) on the first bank layer (225); and
a touch sensor layer (500) between the encapsulation layer (400) and the second bank layer (610),
wherein the light control layer (620) is directly on the touch sensor layer (500).

6. The display apparatus (10) of claim 3, wherein the light control patterns (621, 622, 623) are spaced apart from the second bank layer (610).

7. The display apparatus (10) of claim 1, wherein a thickness of the second bank layer (610) is greater than a thickness of each of the light control patterns (621, 622, 623).

8. The display apparatus (10) of claim 1, wherein the color filters (630G, 630B, 630R) are on the light control patterns (621, 622, 623), and
each of the color filters (630G, 630B, 630R) covers a top surface (621t) and a side surface (621s) of a corresponding light control pattern (621) among the light control patterns (621, 622, 623).

9. The display apparatus (10) of claim 1, wherein, in the plan view, each of the light control patterns (621, 622, 623) has a circular shape, an elliptical shape, or a polygonal shape.

10. The display apparatus (10) of claim 1, wherein, in the plan view, the first light control patterns (621) have a same size,
the second light control patterns (622) have a same size, and
the third light control patterns (623) have a same size.

11. The display apparatus (10) of claim 1, wherein each of the light control patterns (621, 622, 623) comprises a scattering pattern, and/or
wherein each of the light control patterns (621, 622, 623) comprises a scattering pattern and a light-blocking pattern on the scattering pattern.

12. The display apparatus (10) of claim 11, wherein, in the plan view, the light-blocking pattern of each of the light control patterns (621, 622, 623) has a same shape as a shape of the scattering pattern, and/or
wherein a width of the scattering pattern of each of the light control patterns (621, 622, 623) is greater than or equal to a width of the light-blocking pattern, and/or
wherein a thickness of the scattering pattern of each of the light control patterns (621, 622, 623) is equal to a thickness of the light-blocking pattern.

13. The display apparatus (10) of claim 11, wherein the light-blocking pattern of each of the light control patterns (621, 622, 623) comprises a same material as the second bank layer (610).

14. An electronic device comprising:
a display apparatus (10) comprising a display module (11);
a processor (12);
a memory (13); and
a power module (14),
wherein the display apparatus (10) comprises:
a substrate (100);
sub-pixels comprising first color sub-pixels, second color sub-pixels and third color sub-pixels each comprising a sub-pixel electrode (210B, 210G, 210R) on the substrate (100), an emission layer (222B, 222G, 222R) on the sub-pixel electrode (210B, 210G, 210R), and an opposite electrode (230) on the emission layer (222B, 222G, 222R);
a first bank layer (225) comprising lower openings defining an emission area in each of the sub-pixels;
a second bank layer (610) on the first bank layer (225) and comprising upper openings respectively overlapping the lower openings;
a light control layer (620) comprising light control patterns (621, 622, 623) spaced apart from each other on the first bank layer (225) and respectively corresponding to the sub-pixels; and
color filters (630G, 630B, 630R) on the second bank layer (610) and comprising first color filters (630G), second color filters (630B), and third color filters (630R),
the light control patterns (621, 622, 623) comprise first light control patterns (621) respectively corresponding to the first color sub-pixels, second light control patterns (622) respectively corresponding to the second color sub-pixels, and third light control patterns (623) respectively corresponding to the third color sub-pixels,
the first light control patterns (621) comprise a first-1 light control pattern (621a) and a first-2 light control pattern (621b) respectively corresponding to two first color sub-pixels adjacent to each other among the first color sub-pixels, and
in a plan view, the first-1 light control pattern (621a) and the first-2 light control pattern (621b) are at different positions in at least one of a first direction or a second direction perpendicular to the first direction with respect to a center of the first color sub-pixel corresponding thereto.

15. The electronic device of claim 14, wherein, in the plan view, each of the light control patterns (621, 622, 623) is in an emission area of a corresponding sub-pixel among the sub-pixels,
the color filters (630G, 630B, 630R) are respectively on the light control patterns (621, 622, 623),
each of the color filters (630G, 630B, 630R) covers a top surface (621t) and a side surface (621s) of a corresponding light control pattern (621) among the light control patterns (621, 622, 623), and
each of the light control patterns (621, 622, 623) comprises a scattering pattern and a light-blocking pattern on the scattering pattern.
